# EUROPEAN PATENT APPLICATION

(11) **EP 1 621 517 A1**
(43) Date of publication of application: **01.02.2006**
(21) Application number: 04729214.9
(22) Date of filing: 23.04.2004
(51) Int. Cl.: B82B 3/00, H01L 21/027, G03F 7/004, H01L 29/06, H01L 51/00

(54) **METHOD OF BONDING MOLECULE AND MOLECULE BONDING APPARATUS**

(30) Priority: 25.04.2003 JP 2003122629
(71) Applicant: National Institute of Information and Communications Technology, Koganei-shi, Tokyo 184-8795 (JP)
(72) Inventor: OTOMO, Akira, c/o NAT. INSTITUTE OF INFORMATION, Koganei-shi, Tokyo 184-8795 (JP); FURUMI, Seiichi, c/o NAT. INSTITUTE OF INFORMATION, Koganei-shi, Tokyo 184-8795 (JP); SUZUKI, Hitoshi, c/o NAT. INSTITUTE OF INFORMATION, Koganei-shi, Tokyo 184-8795 (JP); MIKI, Hideki, c/o NAT. INSTITUTE OF INFORMATION, Koganei-shi, Tokyo 184-8795 (JP); MASHIKO, Shinro, c/o NAT. INSTITUTE OF INFORMATION, Koganei-shi, Tokyo 184-8795 (JP)
(74) Representative: Turner, James Arthur
(86) International application number: PCT/JP2004/005877
(87) International publication number: WO 2004/096698

(57) **Abstract**

External energy is fed to N-[3-{3,5-bis{3,5-bis[3,5-bis(4-mercaptobenzylthio)benzylthio]benzylthio}benzyloxy}-propionyl-4-nitro-1-naphthylamine (18a) being a molecule capable of photosensitization as an intermediate excitation medium, fixed on support (12) of a metal, so as to photosensitized molecule of excited triplet state (18b), thereby inducing an excited triplet energy transfer from this photosensitized molecule to first molecule (28a) having a residue capable of bonding. The first molecule (28b) having thus been excited by the excited triplet energy transfer is bonded with second molecule (30) having a residue capable of bonding which is a bonding object to be bonded with the first molecule.

## Description

### TECHNICAL FIELD

The present invention relates to a molecular bonding device and molecular bonding method capable of achieving bonding between molecules and arrangement of molecules with a resolution in single-molecule units.

### BACKGROUND ART

There is demand in the semiconductor device field for technologies capable of providing even greater miniaturization and densification

Conventionally, photolithography, electron beam lithography and microfabrication techniques using scanning probe microscopes and near-field probes have been used to form resist patterns for example based on the circuit designs of semiconductor devices.

Specifically, in electron beam lithography and photolithography using direct writing methods, resist patterns are formed by selectively polymerizing molecules with each other by exposing them to light or electrons (see for example NON PATENT DOCUMENT 1).

In methods using scanning probe microscopy, resist patterns are formed using (1) polymerization or oxidation by electrical excitation (see for example NON PATENT DOCUMENTS 2); (2) catalytic reactions (see for example NON PATENT DOCUMENT 3); or (3) the dip pen system (see for example NON PATENT DOCUMENT 4). In methods using near-field light probes, resist patterns are formed by photopolymerizing molecules with each other by exposing them to near-field light (see for example NON PATENT DOCUMENT 5).
NON PATENT DOCUMENT 1
   Nanotechnology and Polymers, Ed. The Society of Polymer Science Japan, NTS, second lecture, "The Role of Polymers in Nanofabrication"
NON PATENT DOCUMENT 2
   Y. Okawa and M. Aono, *Nature* 409, 683 (2001); Y. Okawa and M. Aono, J. *Chem. Phys.* 115, 2317 (2001); G. Dujardrin, R. E. Walkup, Ph. Avouris, *Science* 255, 1232 (1992))
NON PATENT DOCUMENT 3
   B. J. McIntyre, M. Salmeron and G. A. Somorjai, *Science* 265, 1415-1418 (1994)
NON PATENT DOCUMENT 4
   R. D. Piner, J. Zhu, F. Xu, S. Hong and C. A. Mirkin, *Science* 283, 661-663 (1999)
NON PATENT DOCUMENT 5
   T. Ono and M. Esashi, *Jpn. J. Appl. Phys.* 37, 6745-6749 (1998); S. Tanaka et al., *Jpn. J. Appl. Phys.* 37, 6739-6744 (1998); Y. Yamamoto et al., *Appl. Phys.* Lett. 76, 2173 (2000)

However, because of the problems explained below it has been difficult to microfabricate resist patterns by the methods described above with single-molecule resolution in order to meet recent demands for miniaturization and densification of semiconductor devices.

For example, in the case of photopolymerization using the aforementioned photolithography methods, the resolution of the resist pattern is limited to about the half-wave length of the irradiating light. Moreover, in the case of polymerization using electron beam lithography, the resolution of the resist pattern is limited by the focal shape (about 5 nm dia.) of the electron beam.

In the case of resist pattern formation using a scanning probe microscope, the following problems occur corresponding to (1) through (3) above. (1): It is difficult to obtain high resolution with good reproducibility due to changes in the conduction characteristics accompanying deformation of the tip shape of the probe. (2): Not only is resolution limited by the tip shape of the probe as in (1), but it is difficult to control the catalytic reaction field because a catalytic reaction occurs constantly in the presence of a reaction source.
(3): Resolution in this case is limited by the relationship between the volume of liquid dripping from the probe and the wettability of the substrate onto which the liquid drips.

Moreover, when using a near-field light probe the resolution of the resist pattern is limited by the size of the near-field light.

There is demand for a method to resolve the aforementioned issues, allowing a resist pattern to be formed with single-molecule resolution.

As an alternative to conventional semiconductor devices, new devices have been developed, including molecular devices in which multiple functional molecules capable of operating in dimensions of single molecule units are arranged precisely. At present, however, many technological problems need to be resolved so that specific functional molecules can be arranged molecule by molecule in specific positions.

It is therefore an object of the present invention to provide a molecular bonding device and molecular bonding method which are suitable for use in the manufacture of semiconductor devices, molecular devices and the like and which allow bonding between molecules and arrangement of molecules with resolution in single-molecule units.

### DISCLOSURE OF THE INVENTION

The molecular bonding method of the present invention is as follows.

That is, external energy is supplied to an intermediate excitation medium fixed on a support to excite the intermediate excitation medium, causing a first molecule having a bonding residue which is in the vicinity of the intermediate excitation medium to achieve bonding with a bonding target which is to be bonded to the first molecule.

With such a molecular bonding method, not only can bonding between the first molecule and the bonding target be accomplished by means of the stable excited state of the intermediate excitation medium, but resolution in single molecule units (that is, on a nanometer scale) can be obtained with good control.

Moreover, this bonding may be preferably accomplished with either one or both of the first molecule having a bonding residue and the bonding target fixed on a fixing member.

This bonding may be also preferably accomplished with a positioning accuracy of the support relative to the fixing member sufficient to achieve bonding.

In this way, bonding between the first molecule and the bonding target can be achieved more reliably based on the intermediate excitation medium.

For purposes of bonding, the positioning accuracy of the support relative to the support member may be preferably 1 nm or less.

For example, when the intermediate excitation medium or the functional molecule described below is an aromatic molecule, given that the size of each benzene ring is about 0.28 nm, the size of an intermediate excitation medium or functional molecule composed of multiple benzene rings is about 1 nm. Consequently, in order to achieve precise arrangement of a functional molecule or bonding with molecular accuracy based on the intermediate excitation molecule, a positioning accuracy of 1/10 of that or 0.1 nm is thought to be necessary. When the intermediate excitation medium is a nanoparticle such as a quantum dot or the like about 10 nm in size, a positioning accuracy of 1/10 of that or 1 nm is thought to be necessary. Thus, bonding with molecular-scale accuracy can be accomplished if the misalignment of the support with respect to the fixing member is no more than 1 nm.

Moreover, bonding may be preferably accomplished by means of bonding energy which moves from the excited intermediate excitation medium to the first molecule.

Thus, the first molecule, which is within the range of transferring the energy to be used for bonding from the excited intermediate excitation medium, can be bonded with the bonding target to be bonded to the first molecule. When bonding is achieved in this way, resolution can be achieved with good control in single-molecule units based on the intermediate excitation medium.

Transfer of energy to be used for bonding from the intermediate excitation medium to the first molecule can preferably be excited triplet energy transfer.

In this way, not only can the arrival range of the energy for bonding be controlled to within about 1 nm, thus improving positioning accuracy, but the first molecule and bonding target can be bonded with low external energy (sometimes called excitation energy).

Moreover, bonding can preferably be accomplished due to electron transfer between the excited intermediate excitation medium and the first molecule.

In this way, the first molecule, which is radical ionized by means of transfer of electrons between the excited intermediate excitation medium and the first molecule, can be bonded to the bonding target which is to be bonded to the first molecule. In this way resolution can be achieved with good control in single-molecule units based on the intermediate excitation medium.

The external energy may be preferably supplied by supplying light, electrons or ions to the intermediate excitation medium.

Moreover, when the intermediate excitation medium is a photosensitized molecule, the external energy may be preferably supplied by means of exposure to light.

In this way, photoexcited energy transfer or photoexcited electron transfer, which is a photosensitized reaction stemming from the photosensitized molecule, can be used for bonding.

Moreover, a N-acetyl-4-nitro-1-naphthylamine derivative can preferably be used as the photosensitized molecule.

When the intermediate excitation medium may be a photocatalyst, the external energy may be preferably supplied by means of exposure to light.

In this way, a photocatalytic reaction from the photocatalyst can be used in this bonding.

Titanium dioxide can preferably be used as the photocatalyst.

Moreover, a second molecule having a bonding residue can preferably be used as the bonding target.

A material other than a molecule can also preferably be used as the bonding target.

The molecular bonding device of the present invention has the following constitution.

That is, it is provided with a support, an intermediate excitation medium fixed on the support, and an external energy supply source which supplies the intermediate excitation medium with external energy so as to excite the intermediate excitation medium, causing a first molecule having a bonding residue, which is in the vicinity of the excited intermediate excitation medium, to bond with a bonding target which is to be bonded to the first molecule.

With such a molecular bonding device, not only can bonding between the first molecule and the bonding target be accomplished via the stable excited state of the intermediate excitation medium, but resolution in single-molecule units can be achieved with good control based on the intermediate excitation medium.

Moreover, with such molecular bonding device there is no worry of resolution being limited by light or electrons as in conventional lithography by direct excitation, and no worry of resolution being limited by probe tip shape as it is with a scanning probe microscope or near-field probe.

Consequently, using such a molecular bonding device a semiconductor device can be manufactured with greater miniaturization and densification than in the past.

Moreover, molecular devices and other novel devices can be manufactured with such a molecular bonding device because it allows functional molecules capable of operating on a scale of single molecules to be arranged in specific positions with great accuracy.

Preferably either one or both of the first molecule and the bonding target can be fixed on a fixing member.

The support may be preferably positioned with sufficient accuracy with respect to the fixing member so as to achieve bonding.

In this way, bonding between the first molecule and the bonding target can be achieved more reliably.

The positioning accuracy of the support with respect to the fixing member may be preferably 1 nm or less.

For example, when the intermediate excitation medium or the functional molecule described below is an aromatic molecule, given that the size of each benzene ring is about 0.28 nm, the size of an intermediate excitation medium or functional molecule composed of multiple benzene rings is about 1 nm. Consequently, in order to achieve precise arrangement of a functional molecule or bonding with molecular accuracy based on an intermediate excitation molecule, a positioning accuracy of 1/10 of that or 0.1 nm is thought to be necessary. When the intermediate excitation medium is a nanoparticle such as a quantum dot or the like about 10 nm in size, a positioning accuracy of 1/10 of that or 1 nm is thought to be necessary. Thus, bonding with molecular-scale accuracy can be accomplished if the misalignment of the support with respect to the support member is no more than 1 nm.

Moreover, the excited intermediate excitation medium preferably generates bonding energy which moves from the excited intermediate excitation medium to the first molecule to accomplish bonding.

Thus, the first molecule, which is within the range of transferring the energy to be used for bonding from the excited intermediate excitation medium, can be bonded with the bonding target to be bonded to the first molecule. When bonding is achieved in this way, resolution can be achieved with good control in single-molecule units based on the intermediate excitation medium.

Moreover, the excited intermediate excitation medium preferably accomplishes this bonding by electron transfer between the excited intermediate excitation medium and the aforementioned first molecule.

In this way, the first molecule, which is radical ionized by means of transfer of electrons between the excited intermediate excitation medium and the first molecule, can be bonded to the bonding target which is to be bonded to the first molecule. In this way resolution can be achieved with good control in single-molecule units based on the intermediate excitation medium.

The external energy can preferably be light, electrons or ions.

When the intermediate excitation medium may be a photosensitized molecule, the external energy is preferably light.

In this way, a constitution can be achieved which uses photoexcited energy transfer or photoexcited electron transfer, which are photosensitized reactions stemming from the photosensitized molecule.

The photosensitized molecule can preferably be a N-acetyl-4-nitro-1-naphthylamine derivative.

When the intermediate excitation medium is a photocatalyst, the external energy is preferably light.

In this way, a device constitution can be achieved which uses a photocatalytic reaction caused by the photocatalyst.

The photocatalyst can preferably be titanium dioxide.

The bonding target can preferably be a second molecule having a bonding residue.

The bonding target can also preferably be a material other than a molecule.

The intermediate excitation medium can preferably be fixed to the support by chemical bonds.

In this way, because the intermediate excitation medium can be fixed to the support not by an adhesive but by selective chemical bonds (also called chemical adsorption) such as coordinate bonds, covalent bonds, ionic bonds or the like, there is no risk of reliability declining due to deterioration of the adhesive.

The bonding residue may preferably be an aliphatic residue having an unsaturated double bond or unsaturated triple bond.

The bonding residue may also preferably be an aromatic residue having an unsaturated double bond or unsaturated triple bond.

When the aromatic residue having an unsaturated double bond is a cinnamic acid group, the intermediate excitation medium is preferably N-[3-{3,5-bis{3,5-bis[3,5-bis(4-mercaptobenzylthio)benzylthio]benzylthio}benzyloxy}-propionyl-4-nitro-1-naphthylamine.

### BRIEF DESCRIPTION OF THE DRAWINGS

Figures 1 (A) and 1 (B) are simplified cross-sections which help to explain the molecular bonding device of the first embodiment of the present invention.
Figures 2(A), 2(B) and 2(C) are simplified cross-sections which help to explain the molecular bonding method of the first embodiment of the present invention.
Figures 3(A) and 3(B) are simplified cross-sections which help to explain the molecular bonding device of the second embodiment of the present invention.
Figures 4(A), 4(B) and 4(C) are simplified cross-sections which help to explain the molecular bonding method of the second embodiment of the present invention.
Figures 5(A) and 5(B) are simplified cross-sections which help to explain the molecular bonding device of the third embodiment of the present invention.
Figures 6(A), 6(B) and 6(C) are simplified cross-sections which help to explain the molecular bonding method of the third embodiment of the present invention.

### BEST MODE FOR CARRYING OUT THE INVENTION

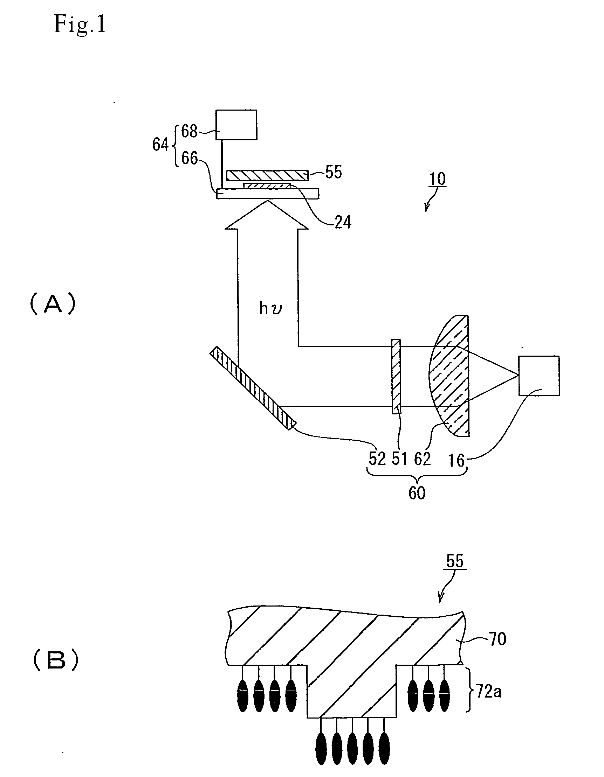

The embodiments of the present invention will be explained below with reference to Figures 1 through 6. In these figures the various constitutional elements, sizes and arrangements are only explained in simplified form so that the invention can be understood, and the present invention is not limited by these illustrated examples. Moreover, while specific materials, conditions and the like may be used in the following explanations, these materials and conditions are only desirable examples and do not limit the invention in any way.

### (First Embodiment)

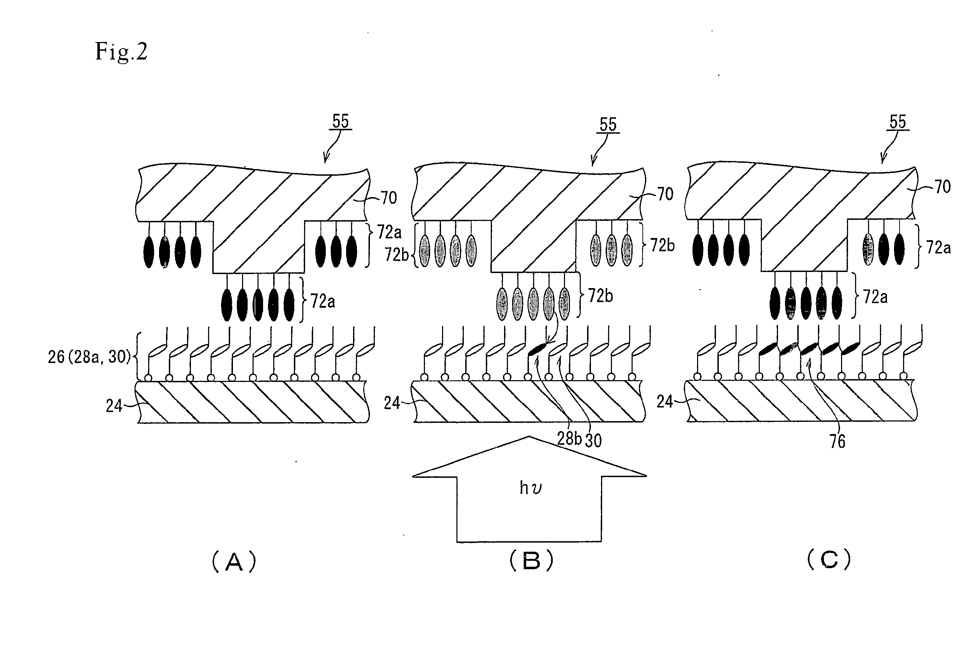

A first embodiment of the present invention will be explained with reference to Figures 1 and 2. Figures 1(A) and 1(B) are partial cross-sections showing the configurations of the molecular bonding device of the present invention and its principal part. Figure 2 is a simplified partial cross-section explaining the molecular bonding method of this embodiment.

As shown in Figure 1(A), molecular bonding device 10 of this embodiment comprises principally support 70, intermediate excitation medium 72a and external energy source 60. Intermediate excitation medium 72a is fixed on support 70, and support 70 and intermediate excitation medium 72a make up mask part 55 of molecular bonding device 10 (see Figure 1(B)).

In the sample configuration of Figure 1(A), molecular bonding device 10 also comprises as a fixing member substrate 24 and fixing device 64 of substrate 24.

External energy supply 60 comprises light source 16 as the external energy supply source, lens 62, filter 51 (here a band-pass filter) and mirror 52. External energy supply 60 supplies intermediate excitation medium 72a of mask part 55 with external energy (also called excitation energy) for exciting this intermediate excitation medium 72a (described below) to this intermediate excitation medium 72a. Specifically, intermediate excitation medium 72a is exposed to excitation light (hv) from light source 16 which has been focused by lens 62 and then reflected by mirror 52 via filter 51. Light source 16 here is for example a mercury xenon lamp.

Fixing device 64 of substrate 24 comprises stage 66 and vacuum pump 68. Fixing device 64 functions as a vacuum chuck which drives vacuum pump 68, fixes substrate 24 on stage 66 and positions substrate 24 and mask part 55 facing each other at a fixed distance.

Next, mask part 55 of this embodiment is explained in detail below.

Support 70 of this mask part 55 is formed by a monocrystalline gold (Au) substrate. In this sample configuration, the surface of the gold substrate facing substrate 24 is formed in a relief or uneven pattern with a width of 20 nm and a height of 10 nm. This relief pattern can be designed and formed based on the desired shape of the resist pattern to be formed on substrate 24.

Moreover, intermediate excitation medium 72a is a medium which contributes indirectly to a specific reaction when it absorbs external energy and becomes excited.

In the sample of this embodiment, the N-(7-mercaptohexanoyl)-4-nitro-1-naphthylamine shown by Formula (1) below is used as intermediate excitation medium 72a. That is, a photosensitized molecule which is a N-acetyl-4-nitro-1-naphthylamine derivative is used as intermediate excitation medium 72a here. Of the N-acetyl-4-nitro-1-naphthylamine derivative, which is a photosensitized molecule, it is the N-acetyl-4-nitro-1-naphthylamine part which has the photosensitization effect, but the derivative as a whole which has the part with the photosensitization effect is sometimes called the photosensitized molecule here.

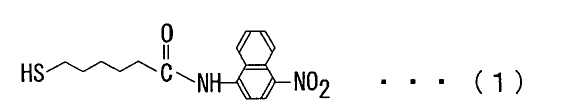

Intermediate excitation medium 72a is not limited to being an N-acetyl-4-nitro-1-naphthylamine derivative, and any that functions as a photosensitized molecule can be selected. As intermediate excitation medium 72a, a crystal particle or the like which is a photocatalyst can also be used instead of a photosensitized molecule. An inorganic material which is a photocatalyst has better chemical stability, thermal stability and the like than an organic material which is a photosensitized molecule. The choice of what substance to use as the intermediate excitation medium can be made at will depending on the objective, bonding conditions and the like.

In this sample configuration, the mercapto groups (-SH groups) at the ends of intermediate excitation medium 72a bond to the gold crystals of support 70, creating Au-S bonds which fix intermediate excitation medium 72a to support 70. That is, because intermediate excitation medium 72a is fixed to support 70 by selective chemical adsorption, there is no risk of reliability declining due to deterioration of the adhesive as there is when fixing is by means of a synthetic resin or other adhesive. The form of selective chemical adsorption can be selected at will from coordinate bonding, covalent bonding, ionic bonding and the like depending on the objective and design.

One example of a method of manufacturing the intermediate excitation medium N-(7-mercaptohexanoyl)-4-nitro-1-naphthylamine is explained below. In this example, the following steps (A) through (C) are performed in sequence.

### (A) Manufacture of 7-bromo-hexanoyl chloride

1.0 g of the 7-bromohexanoic acid shown by Formula (2) below and 5.7 g of thionyl chloride (SOCl₂) were dissolved in 30 ml of benzene (C₆H₆), and circulated for 5 hours.

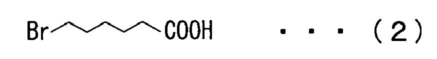

Next, the benzene and thionyl chloride were distilled off under reduced pressure to obtain the 7-bromo-hexanoyl chloride shown by Formula (3) below as a brown liquid.

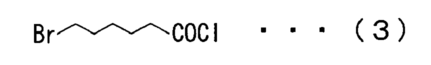

### (B) Manufacture of N-(7-bromohexanoyl)-4-nitro-1-naphthylamine

0.7 g of the 1-amino-4-nitronaphthalene shown by Formula (4) below and triethylamine ((C₂H₅)₃N) were dissolved in a dichloromethane (CH₂Cl₂) solution, and cooled to 0°C in a flow of nitrogen gas. Next, 5 ml of a dichloromethane solution containing 1.0 g of the 7-bromo-hexanoyl chloride obtained in (A) was dripped into this solution, agitated for 2 hours, and then agitated for a further 8 hours at room temperature. The precipitated salts were filtered and the solvent was distilled off under reduced pressure. The resulting raw product was re-crystallized to obtain 1.1 g of the N-(7-bromohexanoyl)-4-nitro-1-naphthylamine shown by Formula (5) below as a yellow solid.

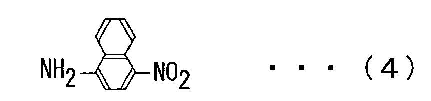

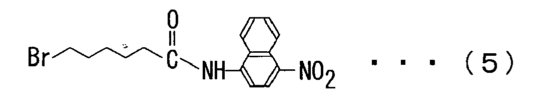

### (C) Manufacture of the intermediate excitation medium N-(7-mercaptohexanoyl)-4-nitro-1-naphthylamine

0.8 g of the N-(7-bromohexanoyl)-4-nitro-1-naphthylamine obtained in (B) and 0.2 g of sodium thioacetate (CH₃COSNa) were dissolved in 30 ml of ethanol, circulated for 24 hours and cooled to room temperature. After cooling, the precipitated solid matter was washed in ethyl acetate (CH₃COOC₂H₅) to obtain a yellow solid. This yellow solid and 0.1 g of potassium hydroxide (KOH) were dissolved in 20 ml of isopropyl alcohol ((CH₃)₂CHOH), circulated for 3 hours and cooled to room temperature.
After cooling and further addition of water, the raw product was extracted with dichloromethane (CHCl₂). Next, after the solvent had been distilled off under reduced pressure, this was re-crystallized to obtain 0.5 g of the yellow solid N-(7-mercaptohexanoyl)-4-nitro-1-naphthylamine shown by Formula (1) above.

Next, the N-(7-mercaptohexanoyl)-4-nitro-1-naphthylamine, which is intermediate excitation medium 72a, is fixed to support 70 by the following procedures.

First, 0.5 mmol/L of a chloroform (CHCL₃) solution of N-(7-mercaptohexanoyl)-4-nitro-1-naphthylamine is prepared. This chloroform solution is then applied by dip coating to the relief or uneven-patterned surface of support 70. The relief-patterned surface is then washed with chloroform. After washing, intermediate excitation medium 72a, which is provided with mercapto groups bonded to the gold surface of support 70 by Au-S bonds, is left fixed on support 70.

Mask part 55 (also called the excited triplet mask) is thus obtained comprising multiple intermediate excitation mediums 72a fixed on the surface of the relief or uneven-patterned surface of support 70. The configuration of support 70 is not limited to the above, and for example a pattern made of a material which is selectively adsorbed by (forms covalent bonds, coordinate bonds, ion bonds or the like with) the intermediate excitation medium could also be formed on regions corresponding to the desired resist pattern. Consequently, a configuration is also possible having a gold pattern corresponding to the bumps of support 70 in this embodiment on a glass (SiO₂) substrate surface. Moreover, an extra-high pressure mercury lamp, low pressure mercury lamp, xenon lamp, halogen lamp, fluorescent light, gas laser, liquid laser, solid state laser or the like can also be used as light source 16. Ultraviolet light rays, visible light rays, infrared light rays, X-rays or the like can also be used as the light. These light sources and lights can be selected appropriately out of considerations of wavelength and light intensity.

Next, a molecular bonding method using this molecular bonding device 10 is explained with reference to Figures 2(A), 2(B) and 2(C).

This embodiment uses a photosensitization reaction from intermediate excitation medium 72a fixed on support 70. Specifically, an example will be explained of a photosensitization reaction in which a bonding reaction occurs as a result of energy transfer (also called photoexcited energy transfer) from the excited intermediate excitation medium. In this case, the physical effect of the intermediate excitation medium is explained as a polymerization reaction using excited triplet energy transfer, but this example is not limiting and excited singlet energy transfer could also be used for example.

First, in this sample configuration a monolayer molecular film (LB film) of the compound (monomer) defined by the following general formula (6) is formed on the surface of substrate 24: 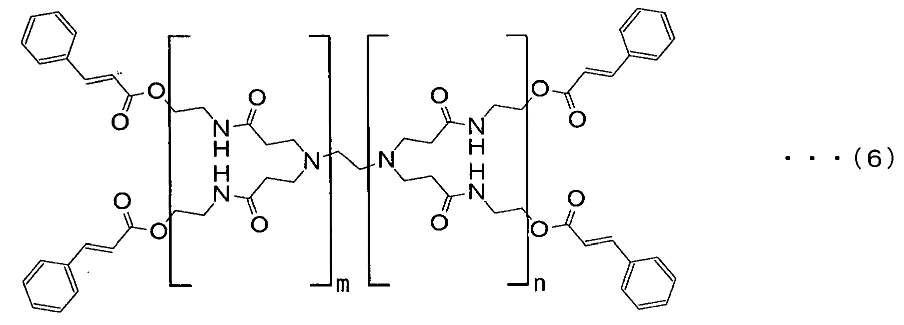 (wherein m and n are each independently natural numbers between 1 and 10).

Specifically the monomer N,N,N',N'-tetra[N",N"-bis {N "' N "' -di-((cinnamoyloxy-ethyl)-carbamoyl-ethyl)-amino-ethylcarbamoyl-ethyl}amino-ethylcarbamoyl-ethyl]ethylenediamine 26 represented by Formula (6') below in which m = n = 3 in Formula (6) above is preferably applied and fixed on substrate 24, which is a sapphire substrate. An example using this compound 26 is explained below.

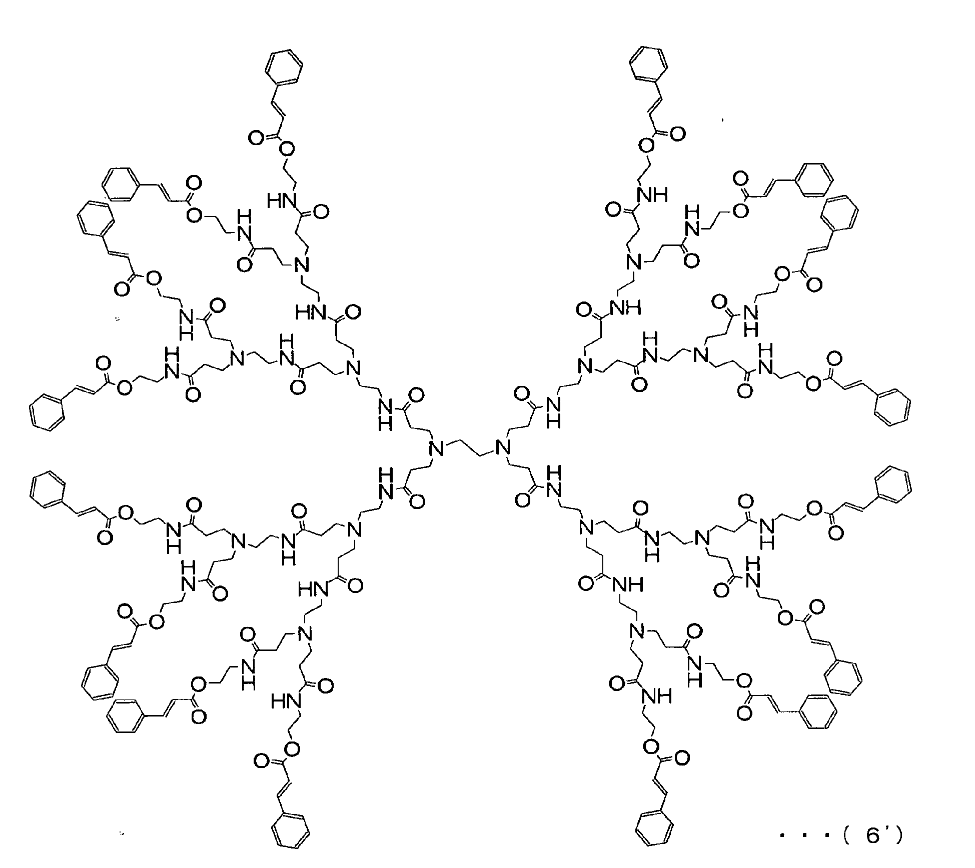

Specifically, first an 0.1 mmol/L chloroform solution of N,N,N',N'-tetra[N",N"-bis{N "' N "' -di-((cinnamoyloxy-ethyl)-carbamoyl-ethyl)-amino-ethylcarbamoyl-ethyl}amino-ethylcarbamoyl-ethyl]ethylenediamine is prepared. A suitable amount of this chloroform solution is then dripped on a water surface and the chloroform is evaporated, forming a monolayer molecular film of N,N,N',N'-tetra[N",N"-bis{N " 'N " '-di-((cinnamoyloxy-ethyl)-carbamoyl-ethyl)-amino-ethylcarbamoyl-ethyl}amino-ethylcarbamoyl-ethyl]ethylenediamine on the water surface. This monolayer molecular film is transferred to the cleaned substrate 24, forming a Langmuir Blodgett (LB) film on substrate 24.

In the example explained here compound 26 is formed as an LB film on substrate 24, but this example is not limiting, and an 0.1 mmol/L chloroform solution of the aforementioned compound 26 could also applied to substrate 24 by spin coating or the like to form a film.

This film of compound 26 can function as a resist film for forming a resist pattern.

The monomer N,N,N',N'-tetra[N",N"-bis{N'''N'''-di-((cinnamoyloxy-ethyl)-carbamoyl-ethyl)-amino-ethylcarbamoyl-ethyl}amino-ethylcarbamoyl-ethyl]ethylenediamine 26 becomes either first molecule 28a (hereunder sometimes called simply the first molecule), which has a bonding residue and is excited by excited triplet energy transfer, or second molecule 30 (hereunder sometimes called simply the second molecule), which has a bonding residue and is the bonding target of the excited first molecule 28b.

In addition to the cinnamic acid group of the N,N,N',N'-tetra[N",N"-bis{N"'N"'-di-((cinnamoyloxy-ethyl)-carbamoyl-ethyl)-amino-ethylcarbamoyl-ethyl}amino-ethylcarbamoyl-ethyl]ethylenediamine, the bonding residue may be for example a vinyl group, acrylate group, methacrylate group or other aliphatic residue having an unsaturated double bond, an alpha-cyanocinnamic acid group, coumarin group, chalcone group, cinnamylidene acetate group, p-phenylenediacrylate group, distyrylpyrazine group or other aromatic residue having an unsaturated double bonds, an acetylene group, diacetylene group or other aliphatic residue having an unsaturated triple bond, a diphenylacetylene group, phenylazide group, dipyridyldiacetylene group or other aromatic residue having an unsaturated triple bond or a group derived from these residues (the same applies in other embodiments).

Next, substrate fixing part 64 is used to fix substrate 24 having an LB film of N,N,N',N'-tetra[N",N"-bis{N'''N'''-di-((cinnamoyloxy-ethyl)-carbamoyl-ethyl)-amino-ethylcarbamoyl-ethyl}amino-ethylcarbamoyl-ethyl]ethylenediamine 26 on stage 66 (see Figure 1(A)), and to arrange N,N,N',N'-tetra[N",N"-bis{N'''N'''-di-((cinnamoyloxy-ethyl)-carbamoyl-ethyl)-amino-ethylcarbamoyl-ethyl}amino-ethylcarbamoyl-ethyl]ethylenediamine 26 on the substrate 24 and the N-(7-mercaptohexanoyl)-4-nitro-1-naphthylamine 72a of mask part 55 facing each other at a specific distance (Figure 2(A)). At this stage when no external energy is being supplied to intermediate excitation medium 72a, no excited triplet energy transfer occurs. At this stage the distance between the surface of substrate 24 and intermediate excitation medium 72a fixed on the bumps of support 70 is preferably no more than 2 nm so as to effectively allow excited triplet energy transfer, or no more than 10 nm in the case of excited singlet energy transfer.

Excitation light as the external energy is next supplied to intermediate excitation medium 72a from the light source, mercury xenon lamp 16. Intermediate excitation medium 72a here is exposed continuously for 10 seconds to light of intensity 2 mW/cm² from mercury xenon lamp 16 which has passed through band-pass filter 51, which has a transmissible wavelength range of 365 nm and a half band width of 10 nm. The light intensity may be any intensity at which at least one photon strikes and excites one intermediate excitation medium 72a, and can be set at will by selecting the configuration and materials of the device and the like.

When exposed to external energy, intermediate excitation medium 72a fixed on support 70 is excited and passes through an excited singlet state to become intermediate excitation medium 72b in an excited triplet state.

As a result, excited triplet energy which is energy to be used for bonding is transferred from intermediate excitation medium 72b in its excited triplet state to a specific first molecule 28a, which is in the vicinity of intermediate excitation medium 72b. Specifically, excited triplet energy is transferred from intermediate excitation medium 72b to first molecule 28a, which is within the transferable range of the excited triplet energy or in other words within a range of 2 nm. That is, each time intermediate excitation medium 72a is excited, one bonding residue of first molecule 28a is excited, resulting in first molecule 28b which has a bonding residue in an excited state. One of the multiple cinnamic acid groups of first molecule 28a is excited each time intermediate excitation medium 72a is excited (Figure 2(B)).

However, because intermediate excitation medium 72b fixed on the indentations of support 70 is about 10 nm away from first molecule 28a, there is no transfer of excited triplet energy, which has an energy transfer range of about 2 nm. That is, with this embodiment excited triplet energy transfer can be made to occur only with respect to the molecule 28a within the range of excited triplet energy from intermediate excitation medium 72b.

As a result, first molecule 28b in its excited triplet state is bonded by polymerization bonding with second molecule 30 which is the bonding target in the vicinity of the first molecule 28b to be bonded with first molecule 28b.

In detail, a polymer with cyclobutane rings is produced by addition polymerization of double bonds in the benzylic position between or within monomers 26.

That is, in this sample embodiment, one of the cinnamic acid groups of first molecule 28a which is excited by one excitation of intermediate excitation medium 72a bonds to one of the multiple cinnamic acid groups of second molecule 30. Alternatively, when second molecule 30 is first molecule 28a itself, one cinnamic acid group of first molecule 28a which is excited by one excitation of intermediate excitation medium 72a bonds to one of the other cinnamic acid groups of the same first molecule 28a. Because polymer patterns differ depending on the polymerization conditions and the like, a desirable polymer pattern can be selected at will according to the objective and design.

In this way, polymer pattern 76 which is a resist pattern having effectively the same shape as the protruding pattern of support 70 can be formed on substrate 24 (see Figure 2(C)).

In this sample configuration, no excited triplet energy transfer occurs as long as intermediate excitation medium 72a is not exposed to excitation light. Moreover, exposure to excitation light is accomplished with intermediate excitation medium 72a and first molecule 28a sufficiently close to one another or in other words with first molecule 28a placed at a distance at which it can be put into an excited state by energy to be used for bonding transferred from intermediate excitation medium 72a.

As a result, in this sample configuration not only can excited triplet energy be transferred effectively, but the positioning accuracy and resolution of polymer pattern 76 on substrate 24 can be controlled on a scale of single molecules based on the intermediate excitation medium.

Next, differences between the material properties (for example, solubility, sublimation temperature or the like) of the monomer and the polymer can be used to form a resist pattern by leaving polymer pattern 76 alone on the substrate. For example, the monomer N,N,N' ,N'-tetra[N",N"-bis{N"'N"'-di-((cinnamoyloxy-ethyl)-carbamoyl-ethyl)-amino-ethylcarbamoyl-ethyl}amino-ethylcarbamoyl-ethyl]ethylenediamine 26 is dissolved by washing the surface of substrate 24 with chloroform, leaving only polymer pattern 76 on substrate 24. Polymer pattern 76, which was formed in response to excitation light exposure, can be recognized by an atomic force microscope (AFM).

As is clear from the explanation above, with this embodiment molecules can be selectively bonded to one another using the transfer of energy generated by excitation of an intermediate excitation medium fixed on a substrate. Moreover, the positioning of the support relative to the substrate can be controlled accurately enough to allow bonding if a positioning apparatus such as a stage 66 having a similar configuration to the stage of a highly accurate atomic force microscope, or in other words a piezo-electric XY positioning stage or the like, is used to position the substrate and support in advance before they are brought into contact with each other. By positioning the support with respect to the substrate with a positioning accuracy of 1 nm or less, resolution in single-molecule units can be achieved with good reproducibility. This is because when the intermediate excitation medium or the functional molecule described below is an aromatic molecule, given that the size of each benzene ring is about 0.28 nm, the size of an intermediate excitation medium or functional molecule composed of multiple benzene rings is about 1 nm. Consequently, in order to achieve precise arrangement of a functional molecule or bonding with molecular accuracy based on the intermediate excitation molecule, a positioning accuracy of 1/10 of that size or 0.1 nm is thought to be necessary. When the intermediate excitation medium is a nanoparticle such as a quantum dot or the like about 10 nm in size, a positioning accuracy of 1/10 of that size or 1 nm is thought to be necessary. Thus, bonding with molecular-scale accuracy can be accomplished if the misalignment of the support with respect to the support member is no more than 1 nm.

Consequently, highly reliable semiconductor devices can be achieved with greater miniaturization and densification than before by applying this molecular bonding method to resist pattern formation and other nanofabrication technologies.

Intermediate excitation medium 72a in this embodiment may be any which has a triplet energy level higher than the triplet energy level of the bonding residue of monomer 26, and the combination of intermediate excitation medium and monomer can be selected at will according to the objective and design. Moreover, a material having functional groups which undergo selective chemical adsorption such as coordinate bonding, covalent bonding, ionic bonding or the like with support 70 can be selected as intermediate excitation medium 72a. To this end, silver (Ag), copper (Cu), platinum (Pt), mercury (Hg), iron (Fe), iron oxide (Fe₂O₃), gallium arsenide (GaAs), indium phosphide (InP) or the like for example can be used as desired as the support as well as gold. For details about combinations of supports and intermediate excitation mediums for selective chemical adsorption, see (1) H. Wolf et al., *J*. *Phys. Chem.* 99, 7102 (1995), (2) P. E. Laibinis and G. M. Whitesides, *J. Am. Chem. Soc.* 114, 1990 (1992), (3) A. Ulman, *Chem. Rev.* 96, 1533 (1996), (4) M. R. Linford and C. E. D. Chidsey, *J. Am. Chem. Soc.* 115, 12630 (1993), (5) M. R. Linford, P. Fenter, P. M. Eisenberger, C. E. D. Chindsey, *J*. *Am. Chem. Soc.* 117, 3145 (1995), (6) J. Sagiv, *J. Am*. *Chem. Soc*. 102, 92 (1980), (7) H. Lee et al., *J*. *Phys. Chem.* 92, 2597 (1988), and (8) D. L. Allara and R. G. Nuzzo, *Langmuir 1,* 52 (1985).

Cases are also included in which the first molecule and the bonding target which is to be bonded to the first molecule are selectively bonded by a polymerization reaction, crosslinking reaction, radical reaction or other reaction.

Since the intermediate excitation medium is fixed to the support by selective chemical adsorption, the aforementioned bonding reactions can be accomplished in a liquid, vacuum or gas atmosphere which allows bonding energy transfer, or within a solid as long as the energy for bonding can be transferred from the surface.

Moreover, monomer 26 is not limited to being fixed as an LB film on substrate 24. It is sufficient for a suitable amount of monomer 26 to be supplied between substrate 24 and intermediate excitation medium 72a. Moreover, the object of energy transfer from excited intermediate excitation medium 72a is not limited to a monomer molecule such as N,N,N',N'-tetra[N",N"-bis{N " 'N " '-di-((cinnamoyloxy-ethyl)-carbamoylethyl)-amino-ethylcarbamoyl-ethyl}amino-ethylcarbamoyl-ethyl]ethylenediamine 26, and may also be a polymer.

### (Second Embodiment)

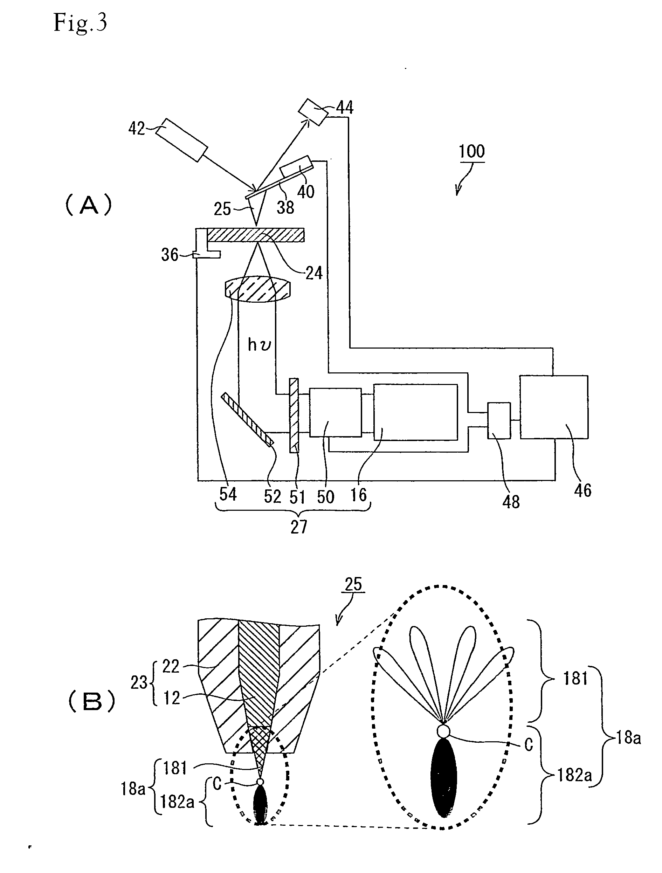

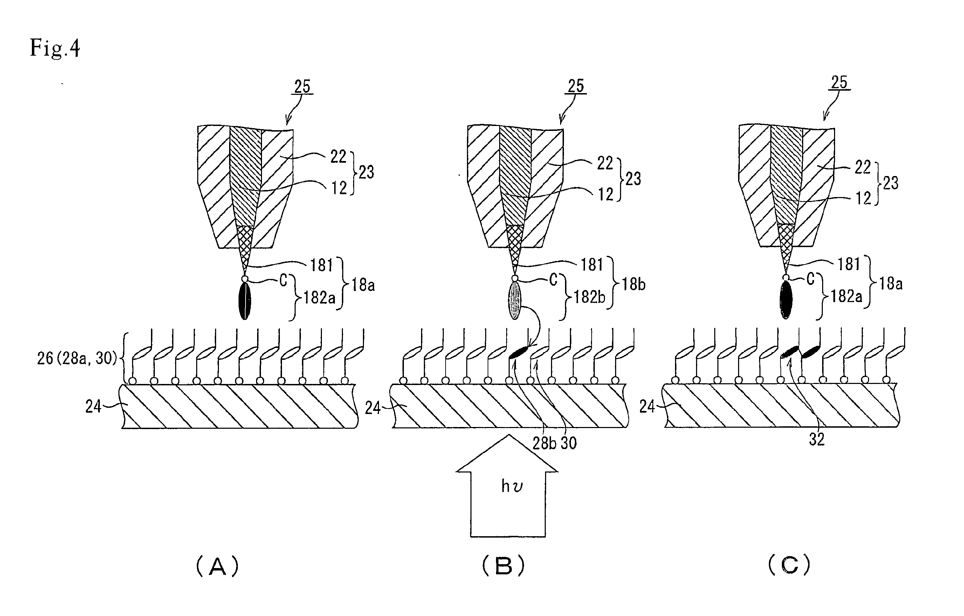

The second embodiment of the present invention will be explained with reference to Figures 3 and 4. Figures 3(A) and (B) are partial cross-sections showing the configurations of the molecular bonding device of this embodiment and the principal part thereof in simplified view. Figure 4 is a simplified partial cross-section which explains the molecular bonding method of this embodiment. This embodiment differs from the first embodiment primarily in that the support of molecular bonding device 100 is formed as a probe structure which is capable of scanning the substrate by means of a limited number of intermediate excitation mediums. Constitutional elements which are the same as constitutional elements which were already explained in the first embodiment will not be explained in detail.

As shown in Figure 3(A), molecular bonding device 100 of this embodiment is provided mainly with probe 25, intermediate excitation medium 18a and external energy supply part 27. Probe 25 is composed of intermediate excitation medium 18a.

In the sample configuration shown in Figure 3(A), molecular bonding device 100 is also provided with substrate 24 as the fixing member, scanner 36, cantilever 38, piezo-electric shaker 40, laser 42, light detector 44, controller 46 and oscillator 48.

External energy supply part 27 is provided with light source 16 as the external energy supply source, shutter 50, filter 51 (here a band-pass filter), mirror 52 and lens 54. Controller 46 here is connected electrically to scanner 36, light detector 44 and oscillator 48. Oscillator 48 is connected electrically to piezo-electric shaker 40 and shutter 50. Scanner 36 supports substrate 24 and can move substrate 24 both along the main plane (orthogonal X and Y directions) and perpendicular (Z direction) to the main plane of substrate 24 in response to signals from controller 46. This configuration allows probe 25 to scan the top of substrate 24. Moreover, under the control of controller 46 this scanner 36 is capable of setting the XY coordinates of substrate 24 with sufficient positioning accuracy so as to allow bonding as described above with respect to the probe tip of probe 25. In particular, by keeping the misalignment of the support with respect to substrate 24 within 1 nm it is possible to accomplish said bonding with accuracy in molecular units (details described below).

Light detector 44 detects light from laser 42 which is reflected by cantilever 38, and outputs signals to controller 46 on the basis thereof. Piezo-electric shaker 40 is attached to one end of cantilever 38 which has probe 25 attached to the other end, and oscillates probe 25 by oscillating cantilever 38 based on signals from oscillator 48. The amplitude, phase and frequency changes of this oscillation are extracted as signals and used to control the spacing between probe 25 and substrate 24. An optical lever system is used here, but the system for controlling the spacing between probe 25 and substrate 24 is not limited thereby, and for example an optical interference system could be used. Shutter 50 blocks or lets pass excitation light from light source 16 based on signals from oscillator 48. External energy supply 27 supplies external energy (also called excitation energy) to intermediate excitation medium 18a which excites intermediate excitation medium 18a described below which is part of probe 25. Specifically, light from light source 16 is reflected from mirror 52, and focused by lens 54 to reach intermediate excitation medium 18a.

Next, probe 25 of this embodiment will be explained in detail below.

As shown in Figure 3(B), probe 25 is mainly provided with support 12 and intermediate excitation medium 18a which is fixed on support 12. In the explanation below, intermediate excitation medium 18a is sometimes called the probe molecule structure.

Support 12 of this embodiment is formed of gold wire with an outer diameter of 4 nm. This gold wire is inserted into glass capillary tube 22 to form double-structured probe body 23. This probe body 23 can be obtained for example by first using a pipette puller (Sutter P2000) to pull a 1 mm outer diameter glass capillary tube with 0.05 mm diameter gold wire inserted therein, and then adjusting the tip of the capillary tube to the bore thickness of 4 nm either by mechanical polishing using a micropipette beveler (Sutter BV-10) with 0.05 µm diameter alumina (Al₂O₃) or the like, or by chemical polishing using a 40 wt% aqueous hydrogen fluoride (HF) solution or the like, or by focused ion beam etching, exposing the gold tip surface. Details are described in "Nanometer-sized electrochemical sensors," Y. Shao et al., *Anal. Chem.* 69, 1627 (1997).

In this embodiment, N-[3-{3,5-bis{3,5-bis[3,5-bis(4-mercaptobenzylthio) benzylthio] benzylthio} benzyloxy}-propionyl-4-nitro-1-naphthylamine, which is the dendrimer structure represented by Formula (7) below, is used as intermediate excitation medium 18a. That is, a photosensitized molecule which is a N-acetyl-4-nitro-1-naphthylamine derivative is used here as intermediate excitation medium 18a.

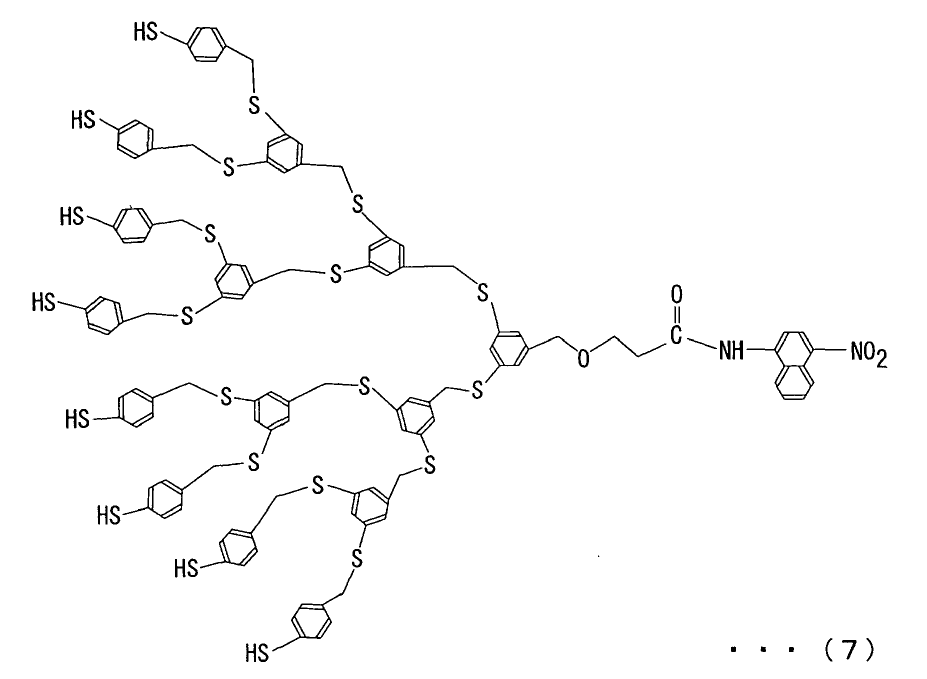

That is, photosensitized molecule 18a, which is the intermediate excitation medium in this embodiment, is provided with probe branch 182a and bonding branch part 181. Specifically, this photosensitized molecule 18a has a tree-like structure in which the multiple bonding branches of bonding branch part 181 branch radially from probe branch 182a.

Specifically, in this sample configuration, probe branch 182a, which is the trunk of the tree-like structure, is the part which functions as the photosensitized molecule and extends towards substrate 24, thus forming the end part of the probe. The multiple bonding branches of bonding branch part 181 of the tree-like structure each have one end bonded to core C (see Figure 3(B)) which is the tip of probe branch 182a or in other words to the -CH₂-O- group of the compound of Formula (7) above, with the other ends spreading radially in three dimensions towards support 12 so as to cover support 12. The bond between photosensitized molecule 18a and support 12 is more secure as a result, so that one molecule of photosensitized molecule 18a can be fixed firmly to support 12.

That is, photosensitized molecule 18a in this sample configuration has multiple substitutional groups as bonding branches which spread radially towards support 12 from core C which is the central framework, and one substitutional group as the probe branch which extends from core C towards substrate 24 and which has a different structure from the substitutional groups which are the bonding branches.

Moreover, because bonding branch part 181 which is the part of photosensitized molecule 18a which bonds to support 12 has a radially spreading structure, the area of support 12 to which photosensitized molecule 18a is fixed does not need to be worked by advanced techniques to a size as small as that of the probe branch. As a result, the desired number of photosensitized molecules can be fixed to support 12 even when it is technically difficult to work this region to the size of probe branch part 182a. Moreover, manufacturing costs can be reduced because advanced fabrication techniques are not needed.

For example, the size of the area of support 12 which bonds to bonding branch part 181 can be an area sufficient for one photosensitized molecule 18a to bond to one support 12 taking into consideration the area of the base of the cone formed by the spreading tips of bonding branch part 181. Moreover, when a given number greater than one of photosensitized molecules 18a are to bond to support 12, the size of the area which bonds to bonding branch parts 181 can be an area sufficient for that number of bonding branch parts 181 to bond to support 12 taking into consideration the area of the base of the cone formed by the spreading tips of bonding branch part 181. In this way, any desired number of photosensitized molecules can be fixed to support 12.

That is, intermediate excitation medium 18a here is a probe molecular structure which is a conical dendrimer structure with an open length of 4 nm having mercapto (-SH) groups at the ends of the branches. As in the first embodiment, the mercapto groups at the ends of intermediate excitation medium 18a bond to the gold of support 12, forming Au-S bonds which fix intermediate excitation medium 18a to support 12. That is, because intermediate excitation medium 18a is fixed to the support by selective chemical adsorption, there is no risk of reliability declining due to deterioration of the adhesive as there would be if the intermediate excitation medium were fixed to support 12 using a synthetic resin or other adhesive. Intermediate excitation medium 18a is not limited to the above, and any which functions as a photosensitized molecule can be selected at will.

One example of a method of manufacturing the intermediate excitation medium N-[3-{3,5-bis{3,5-bis[3,5-bis(4-mercaptobenzylthio)benzylthio]benzylthio}benzyloxy}-propionyl-4-nitro-1-naphthylamine is explained below. In this manufacturing method, the procedures of steps (A) through (L) are performed in that order.

### (A) Manufacture of 3,5-bis(dimethylthiocarbamoyloxy)benzoic acid methyl

16.8 g of the 3,5-dihydroxybenzoic acid methyl shown by Formula (8) below, 22.0 g of the dimethylthiocarbamoyl chloride shown by Formula (9) below, and 30.0 g of potassium carbonate (K₂CO₃) were mixed in 500 ml of acetone (CH₃COCH₃) and reacted with agitation for 24 hours at between 30°C and 35°C. After completion of the reaction, the acetone was distilled off under reduced pressure. 500 ml of ice water was added to the resulting residue, and the precipitated crystals were filtered out and re-crystallized with ethanol (C₂H₅OH) to obtain 32.2 g of the 3,5-bis(dimethylthiocarbamoyloxy)benzoic acid methyl shown by Formula (10) below.

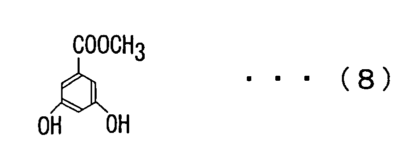

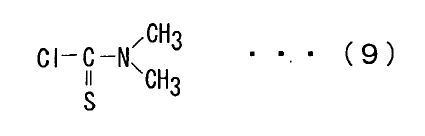

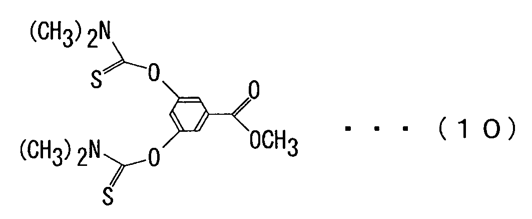

### (B) Manufacture of 3,5-bis(dimethylcarbamoylthio)benzoic acid methyl

32.0 g of the 3,5-bis(dimethylthiocarbamoyloxy)benzoic acid methyl obtained in (A) was added with circulating agitation to 200 ml of the 1,3-dimethyl-2-imidazolidinone shown by Formula (11) below, and maintained at between 220°C and 226°C to accomplish rearrangement. Next, circulating agitation was continued for a further 2 hours, and the 1,3-dimethyl-2-imidazolidinone was distilled off under reduced pressure. 500 ml of ice water was added to the resulting residue, and the precipitated crystals were filtered out and re-crystallized with acetone to obtain 25.3 g of the 3,5-bis(dimethylcarbamoylthio)benzoic acid methyl shown by Formula (12) below.

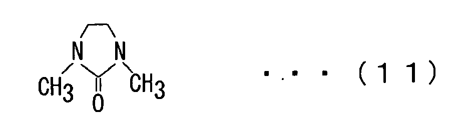

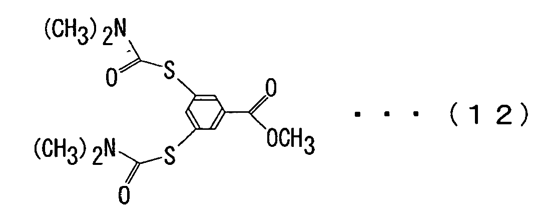

### (C) Manufacture of 3,5-bis(4-dimethylcarbamoylthiobenzylthio)-benzoic acid methyl

25.0 g of the 3,5-bis(dimethylcarbamoylthio)benzoic acid methyl obtained in (B) was dissolved in 300 ml of acetone and 2.1 equivalents of sodium methoxide (CH₃ONa) were added and agitated at room temperature for 2 hours. After completion of agitation, 34.0 g of the 4-dimethylcarbamoylthiobenzyl chloride shown by Formula (13) below was added to the solution and reacted for 3 hours. After completion of the reaction, the acetone was distilled off under reduced pressure. 500 ml of ice water was added to the resulting residue, and the precipitated crystals were filtered out and re-crystallized with methanol to obtain 19.8 g of the 3,5-bis(4-dimethylcarbamoylthiobenzylthio)benzoic acid methyl shown by Formula (14) below.

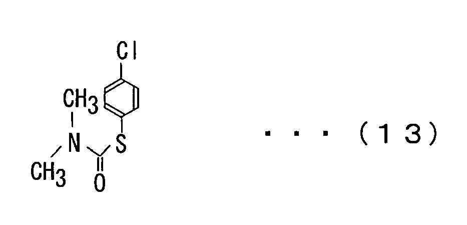

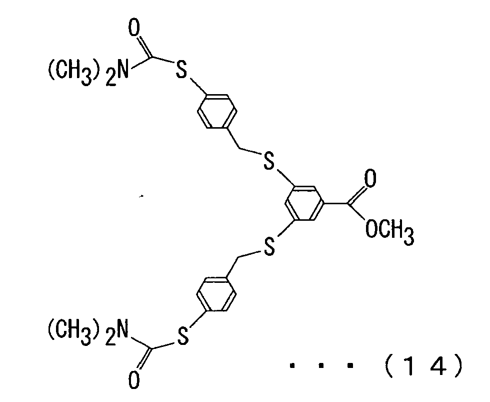

### (D) Manufacture of 3,5-bis(4-dimethylcarbamoylthiobenzylthio)benzyl alcohol

19.5 g of the 3,5-bis(4-dimethylcarbamoylthiobenzylthio)benzoic acid methyl obtained in (C) was dissolved in 300 ml of toluene (C₆H₅CH₃), and a 70 wt% toluene solution containing 1.2 equivalents of sodium hydrogenated bis(2-methoxyethoxy)aluminum was dripped into this solution with agitation over the course of 30 minutes at between 5°C and 10°C in a flow of dry nitrogen (N₂). After completion of dripping, this was reacted for another hour at between 5°C and 10°C in a flow of dry nitrogen. After completion of the reaction, this solution was added with agitation to 500 ml of a 10 wt% hydrochloric acid (HCl) solution which had been cooled to between 0°C and 5°C, and extracted twice with 200 ml of ethyl acetate (CH₃COOC₂H₅). After extraction it was washed successively with saturated sodium chloride solution (sat. NaCl aq) and saturated sodium bicarbonate solution (sat. NaHCO₃ aq), and then dried with magnesium sulfate (MgSO₄). Next, the ethyl acetate was distilled off under reduced pressure, and the residue was purified by silica gel column chromatography (developing solvent: chloroform) to obtain 18.0 g of the 3,5-bis(4-dimethylcarbamoylthiobenzylthio)benzyl alcohol shown by Formula (15) below.

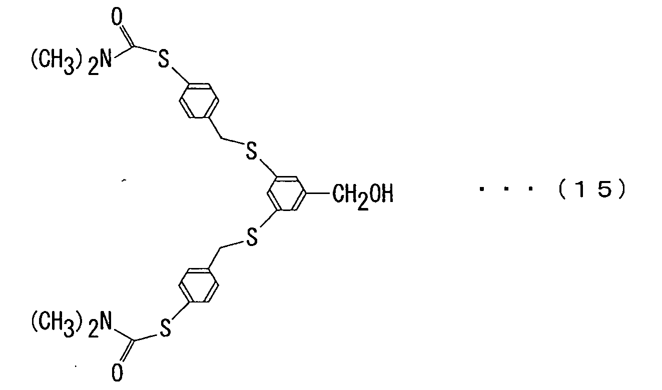

### (E) Manufacture of 3,5-bis(4-dimethylcarbamoylthiobenzylthio)benzyl chloride

18.0 g of the 3,5-bis(4-dimethylcarbamoylthiobenzylthio)benzyl alcohol obtained in (D) was dissolved in 300 ml of carbon tetrachloride (CCl₄), and 1.2 equivalents of triphenylphosphine (Sigma-Aldrich Japan) supported on polystyrene were added with agitation at between 5°C and 10°C in a flow of dry nitrogen. Next, circulating agitation was continued for 2 hours as the temperature was gradually raised, and the temperature was then lowered to room temperature to remove the polystyrene resin. The removed resin was washed twice with 200 ml of chloroform (CHCl₃) and condensed under reduced pressure, and the residue was purified by column chromatography to obtain 17.5 g of the 3,5-bis(4-dimethylcarbamoylthiobenzylthio)benzyl chloride shown by Formula (16) below.

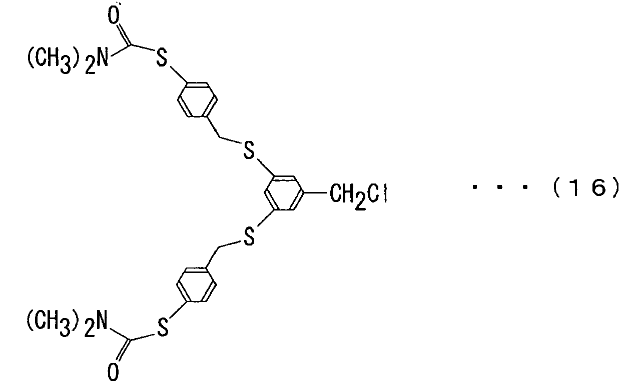

### (F) Manufacture of 3,5-bis[3,5-bis(4-dimethylcarbamoylthiobenzylthio)benzylthio]benzoic acid methyl

5:0 g of the 3,5-bis(dimethylcarbamoylthio)benzoic acid methyl obtained in (B) was dissolved in 300 ml of acetone, and agitated for 2 hours at room temperature after addition of 2.1 equivalents of sodium methoxide. After agitation was complete, 17.0 g of the 3,5-bis(4-dimethylcarbamoylthiobenzylthio)benzyl chloride obtained in (E) was added to this solution and reacted for 3 hours. After completion of the reaction, the acetone was distilled off under reduced pressure. The resulting residue was purified by column chromatography (developing solvent: chloroform) to obtain 14.2 g of the 3,5-bis[3,5-bis(4-dimethylcarbamoylthiobenzylthio)benzylthio]benzoic acid methyl shown by Formula (17) below.

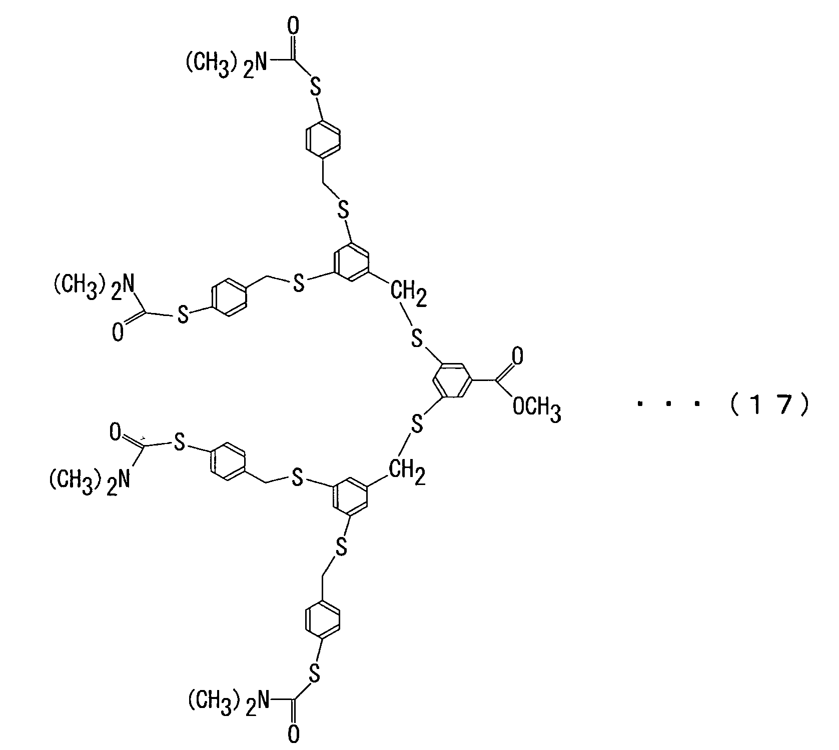

### (G) Manufacture of 3,5-bis[3,5-bis(4-dimethylcarbamoylthiobenzylthio)benzylthio]benzyl alcohol

14.0 g of the 3,5-bis[3,5-bis(4-dimethylcarbamoylthiobenzylthio)benzylthio]benzoic acid methyl obtained in (F) was dissolved in 200 ml of toluene, and a 70 wt% toluene solution containing 1.2 mole of sodium hydrogenated bis(2-methoxyethoxy)aluminum was dripped in over the course of 30 minutes at between 5°C and 10°C in a flow of dry nitrogen. After completion of dripping, this was reacted for another hour at between 5°C and 10°C in a flow of dry nitrogen. After completion of the reaction, this solution was added with agitation to 300 ml of a 10 wt% hydrochloric acid solution which had been cooled to between 0°C and 5°C, and extracted twice with 150 ml of ethyl acetate. After extraction, the organic layer was washed successively with saturated sodium chloride solution and saturated sodium bicarbonate solution, and dried with magnesium sulfate. The ethyl acetate was then distilled off under reduced pressure, and the residue was purified by column chromatography to obtain 12.6 g of the 3,5-bis[3,5-bis(4-dimethylcarbamoylthiobenzylthio)benzylthio]benzyl alcohol shown by Formula (18) below.

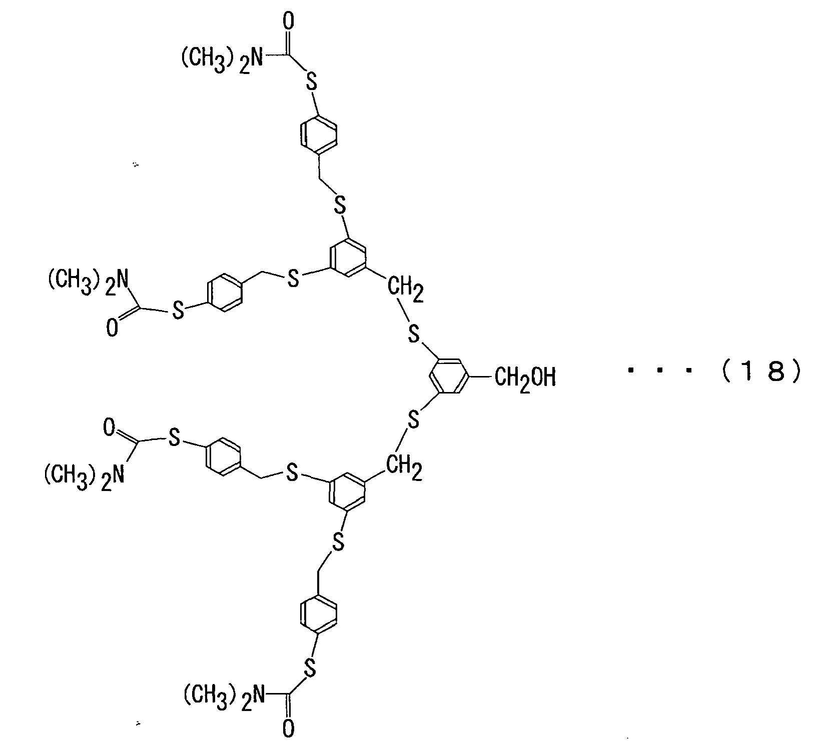

### (H) Manufacture of 3,5-bis[3,5-bis(4-dimethylcarbamoylthiobenzylthio)benzylthio]benzyl chloride

12.5 g of the 3,5-bis[3,5-bis(4-dimethylcarbamoylthiobenzylthio)benzylthio]benzyl alcohol obtained in (G) was dissolved in 200 ml of carbon tetrachloride, and 1.2 equivalents of PS-triphenylphosphine were added with agitation at between 5°C and 10°C in a flow of dry nitrogen. Next, circulating agitation was continued for 2 hours as the temperature was raised gradually, and the temperature was then cooled to room temperature to remove the resin. The removed resin was washed twice with 200 ml chloroform and distilled off under reduced pressure, and the residue was purified by column chromatography to obtain 12.0 g of the 3,5-bis[3,5-bis(4-dimethylcarbamoylthiobenzylthio)benzylthio]benzyl chloride shown by Formula (19) below.

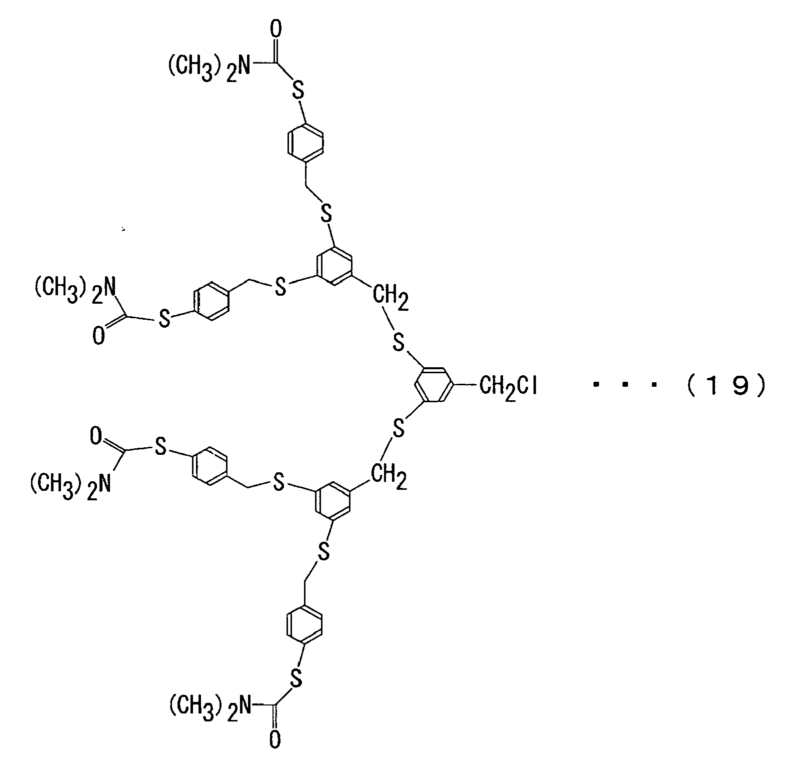

### (I) Manufacture of 3,5-bis{3,5-bis[3,5-bis(4-dimethylcarbamoylthiobenzylthio)benzylthio]benzylthio}benzoi c acid methyl

3.21 g of the 3,5-bis(dimethylthiocarbamoylthio)benzoic acid methyl obtained in (B) was dissolved in 300 ml of acetone, and agitated for 2 hours at room temperature after addition of 2.1 equivalents of sodium methoxide. After agitation was complete, 12.0 g of the 3,5-bis[3,5-bis(4-dimethylcarbamoylthiobenzylthio)benzylthio]benzyl chloride obtained in (H) was added and reacted for 3 hours. After completion of the reaction, the acetone was distilled off under reduced pressure. The resulting residue was purified by column chromatography to obtain 9.81 g of the 3,5-bis {3, 5-bis [3, 5-bis (4-dimethylcarbamoylthiobenzylthio)benzylthio]benzylthio}benzoi c acid methyl shown by Formula (20) below.

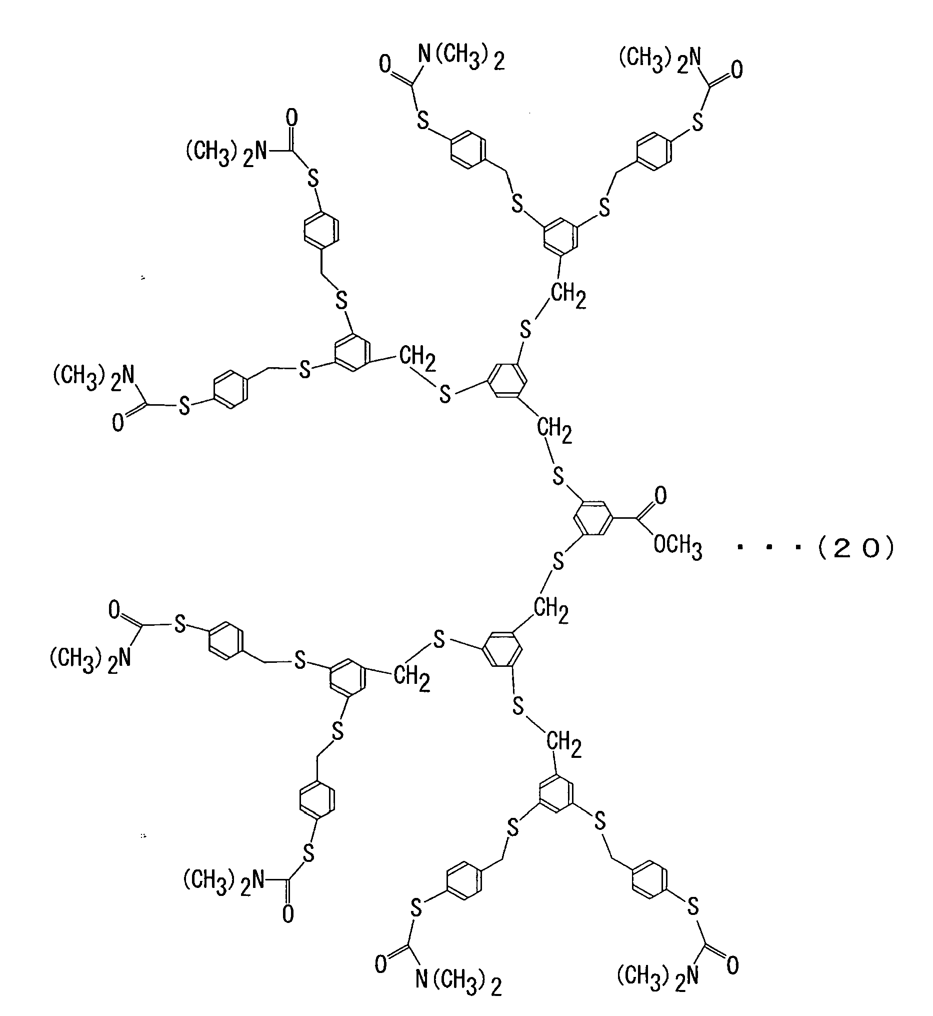

### (J) Manufacture of 3,5-bis{3,5-bis[3,5-bis(4-dimethylcarbamoylthiobenzylthio)benzylthio]benzylthio}benzyl alcohol

9.50 g of the 3,5-bis{3,5-bis[3,5-bis(4-dimethylcarbamoylthiobenzylthio)benzylthio]benzylthio}benzoi c acid methyl obtained in (I) was dissolved in 100 ml of toluene, and a 70 wt% toluene solution containing 1.2 mole of sodium hydrogenated bis(2-methoxyethoxy)aluminum was dripped in over the course of 30 minutes at between 5°C and 10°C in a flow of dry nitrogen. After completion of dripping, this was reacted for another hour at between 5°C and 10°C in a flow of dry nitrogen. After completion of the reaction, this solution was added with agitation to 150 ml of a 10% wt hydrochloric acid solution which had been cooled to between 0°C and 5°C, and extracted twice with 100 ml of ethyl acetate. After extraction, the organic layer was washed successively with saturated sodium chloride solution and saturated sodium bicarbonate solution, and then dried with magnesium sulfate. After the ethyl acetate had been distilled off under reduced pressure, the residue was purified by silica gel column chromatography (developing solvent; chloroform:hexane = 1:1) to obtain 7.20 g of the 3,5-bis{3,5-bis[3,5-bis(4-dimethylcarbamoylthiobenzylthio)benzylthio]benzylthio} benzyl alcohol shown by Formula (21) below.

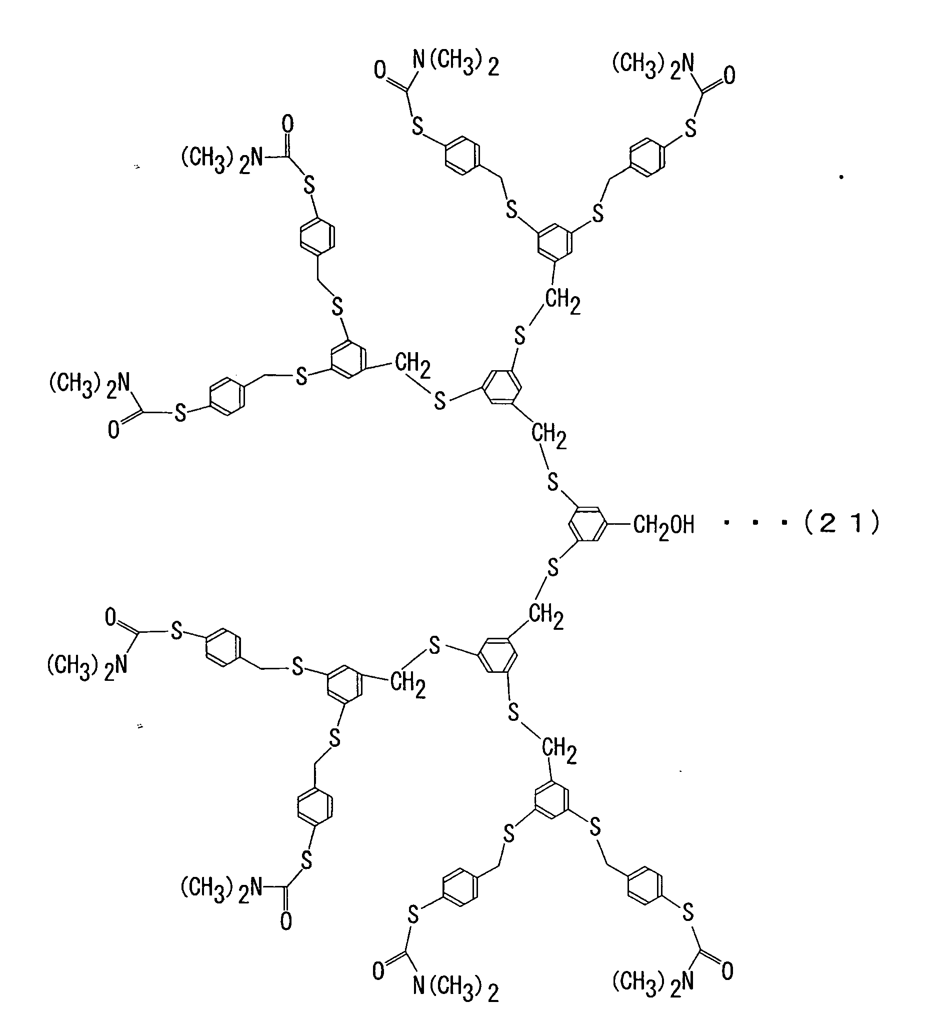

### (K) Manufacture of N-(3-bromopropionyl)-4-nitro-1-naphthylamine

3.23 g of 4-nitronaphthylamine was dissolved in 50 ml of dried tetrahydrofuran solution, and 1.1 equivalents of 3-bromopropionyl chloride dissolved in 10 ml of dried tetrahydrofuran were dripped in with agitation at between 5°C and 10°C in a flow of dry nitrogen. After completion of dripping, the reaction was continued for 2 hours at between 5°C and 10°C in a flow of dry nitrogen. After completion of the reaction, 50 ml of ice water was added under reduced pressure, and the mixture was extracted twice with 50 ml ethyl acetate. After extraction, the organic layer was washed successively with saturated sodium chloride solution and saturated sodium bicarbonate solution, and dried with magnesium sulfate. Next, the ethyl acetate was distilled off under reduced pressure, and the residue was re-crystallized with a small amount of ethanol to obtain 2.65 g of the N-(3-bromopropionyl)-4-nitro-1-naphthylamine shown by Formula (22) below.

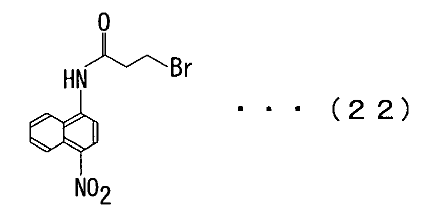

### (L) Manufacture of the intermediate excitation medium, N-[3-{3,5-bis{3,5-bis[3,5-bis(4-mercaptobenzylthio)benzylthio]benzylthio}benzyloxy}-propionyl-4-nitro-1-naphthylamine,

The 3,5-bis{3,5-bis[3,5-bis(4-dimethylcarbamoylthiobenzylthio)benzylthio]benzylthio} benzyl alcohol obtained in (J) was dissolved in 50 ml of dried tetrahydrofuran. Next, a 60 wt% oil suspension containing 1 equivalent of sodium hydride (NaH) was added at between 0°C and 5°C in a flow of dry nitrogen, and agitated for 30 minutes. Next, 2 equivalents of the N-(3-bromopropionyl)-4-nitro-1-naphthylamine obtained in (K) were added at between 0°C and 5°C in flow of dry nitrogen, and reacted for 2 hours at room temperature. After completion of the reaction, this was washed with saturated sodium chloride solution after addition of 50 ml of chloroform, and dried with magnesium sulfate anhydride. After concentration under reduced pressure, the residue was dissolved in 50 ml acetone, and 9.0 equivalents of sodium methoxide were added thereto and agitated for 2 hours at room temperature. After agitation, the acetone was distilled off under reduced pressure. 50 ml of ice water was added to the resulting residue, which was then extracted twice with 30 ml chloroform. After extraction, the organic layer was washed successively with saturated sodium chloride solution and saturated sodium bicarbonate solution, and dried with magnesium sulfate anhydride. After the chloroform had been distilled off under reduced pressure, the residue was purified by column chromatography to obtain 0.62 g of the N-[3-{3,5-bis{3,5-bis[3,5-bis(4-mercaptobenzylthio)benzylthio]benzylthio}benzyloxy}-propionyl-4-nitro-1-naphthylamine shown by Formula (7) above.

Next, the intermediate excitation medium 18a, which is N-[3-{3,5-bis{3,5-bis[3,5-bis(4-mercaptobenzylthio)benzylthio]benzylthio}benzyloxy}-propionyl-4-nitro-1-naphthylamine, is fixed to support 12 by the following procedures.

First, an 0.1 mmol/L chloroform solution of the N-[3-{3,5-bis{3,5-bis[3,5-bis(4-mercaptobenzylthio)benzylthio]benzylthio}benzyloxy}-propionyl-4-nitro-1-naphthylamine is prepared. This chloroform solution is then applied to the gold surface of support 12 by dip coating. Next, the gold surface is washed with chloroform. After washing, intermediate excitation medium 18a, which is a probe molecular structure having mercapto groups which have bonded to the gold surface of support 12, remains fixed to this support 12. A probe 25 (also called a photoexcited triplet probe) comprising one unit of intermediate excitation medium 18a fixed to the tip of support 12 is thus obtained. In this sample configuration, one unit of the intermediate excitation medium is fixed to the tip of support 12, but more than one could also be fixed. Moreover, the method of fixing intermediate excitation medium 18a to support 12 is not limited to the above, and any other suitable method could be used such as one in which the surface area of support 12 is further reduced by causing a gold particle to be adsorbed on the exposed tip, and intermediate excitation medium 18a is then fixed to this gold particle.

Because it is provided principally with probe 25, substrate 24, scanner 36, cantilever 38, laser 42 and light detector 44, this molecular bonding device 100 can also function as an atomic force microscope (AFM), but it need not do so.

Next, a molecular bonding method using this molecular bonding device 100 is explained with reference to Figures 4(A), (B) and (C).

This embodiment uses a photosensitization reaction caused by intermediate excitation medium 18a fixed on support 12. Specifically, the photosensitization reaction explained here is a polymerization reaction using excited triplet energy transfer as in the first embodiment.

First, the monomer N,N,N',N'-tetra[N",N"-bis{N'''N'''-di-((cinnamoyloxy-ethyl)-carbamoyl-ethyl)-amino-ethylcarbamoyl-ethyl}amino-ethylcarbamoyl-ethyl]ethylenediamine 26 is applied and fixed to substrate 24 by methods similar to those used in the first embodiment. These monomers 26 are the probe scanning targets which are scanned by probe 25.

Next, an LB film is formed of N,N,N',N'-tetra[N",N"-bis{N"' N"'-di-((cinnamoyloxy-ethyl)-carbamoyl-ethyl)-amino-ethylcarbamoyl-ethyl}amino-ethylcarbamoyl-ethyl]ethylenediamine 26. Substrate 24 is set on scanner 36 (see Figure 3(A)), and the N,N,N',N'-tetra[N",N"-bis {N "'N "'-di-((cinnamoyloxy-ethyl)-carbamoyl-ethyl)-amino-ethylcarbamoyl-ethyl}amino-ethylcarbamoyl-ethyl]ethylenediamine 26 on substrate 24 is arranged facing the N-[3-{3,5-bis{3,5-bis[3,5-bis(9-mercaptobenzylthio)benzylthio]benzylthio}benzyloxy}-propionyl-4-nitro-1-naphthylamine 18a of probe 25 at a specific distance (see Figure 4(A)). At this stage when no external energy is being supplied to intermediate excitation medium 18a, no excited triplet energy transfer occurs. At this stage the distance between the surface of substrate 24 (and therefore monomer 26) and intermediate excitation medium 18a fixed on support 12 is preferably no more than 2 nm so as to effectively allow excited triplet energy transfer, or no more than 10 nm if excited singlet energy transfer is to be applied. Setting this distance allows effective energy transfer between the intermediate excitation medium and the first molecule.

Next, intermediate excitation medium 18a is supplied with (exposed to) excitation light from a light source (mercury xenon lamp 16) as the external energy.

Specifically, when exposing intermediate excitation medium 18a to excitation light, controller 46 interlocks piezo-electric shaker 40 and shutter 50 by means of oscillator 48 based on signals regarding displacement of probe 25 detected by light detector 44, and causes intermediate excitation medium 18a to be exposed to excitation light when the tip of probe 25 and N,N,N',N'-tetra[N",N"-bis{N " 'N " '-di-((cinnamoyloxy-ethyl)-carbamoylethyl)-amino-ethylcarbamoyl-ethyl}amino-ethylcarbamoyl-ethyl]ethylenediamine 26 have approached to a fixed distance of one another. That is, controller 46 causes probe 25 to oscillate vertically relative to substrate 24, and causes intermediate excitation medium 18a to be exposed to excitation light when intermediate excitation medium 18a at the tip of probe 25 is at its closest point to monomer 26. Intermediate excitation medium 18a here is exposed to pulse light or in other words to intermittent light of intensity 2 mW/cm² from mercury xenon lamp 16 which has passed through band-pass filter 51 with a transmissible wavelength range of 365 nm and a half band width of 10 nm. The light intensity may be any intensity at which one intermediate excitation medium 18a is exposed to and excited by at least one photon, and can be set at will by selecting the configuration and materials of the device and the like.

Exposure to excitation light does not need to be intermittent if the oscillating cycle of oscillator 48 is sufficiently shorter than the relaxation time of the excited state of intermediate excitation medium 18a.

After energy exposure, the intermediate excitation medium 18a fixed to the support 12 is excited and becomes the intermediate excitation medium 18b in its excited triplet state posterior to its excited singlet state. More specifically, from among intermediate excitation mediums 18b, the probe branch 182a functioning as photosensitized molecule becomes the probe branch 182b in an excitation state.

As a result, excited triplet energy which is energy to be used for bonding is transferred from intermediate excitation medium 18b in its excited triplet state to a specific first molecule 28a, which is in the vicinity of intermediate excitation medium 18b. Specifically, excited triplet energy is transferred from intermediate excitation medium 18b to first molecule 28a, which is within the range of the excited triplet energy transfer or in other words within a range of 2 nm. That is, each time intermediate excitation medium 18a is excited, one bonding residue of first molecule 28a is excited, resulting in first molecule 28b, which has a bonding residue in an excited state. One of the multiple cinnamic acid groups of first molecule 28a is excited each time intermediate excitation medium 18a is excited (Figure 4(B)).

That is, with this embodiment excited triplet energy transfer can be made to occur selectively only from intermediate excitation medium 18b to first molecule 28a which is within the transferable range of the excited triplet energy.

As a result, first molecule 28b in its excited triplet state is bonded by a polymerization reaction with second molecule 30, the bonding target which is to be bonded with first molecule 28b and which is in the vicinity of first molecule 28b.

In detail, a polymer with cyclobutane rings is produced by addition polymerization of double bonds in the benzylic position between or within monomers 26. That is, in this sample embodiment, one of the cinnamic acid groups of first molecule 28a which is excited by one excitation of intermediate excitation medium 18a bonds to one of the multiple cinnamic acid groups of second molecule 30. Alternatively, when second molecule 30 is first molecule 28a itself, one cinnamic acid group of first molecule 28a which is excited by one excitation of intermediate excitation medium 18a bonds to one of the other cinnamic acid groups of the same first molecule 28a. Because polymer patterns differ depending on the polymerization conditions and the like, a desirable polymer pattern can be selected at will according to the objective and design.

Polymer 32 can be formed in this way on substrate 24 (Figure 4(C)).

In this sample configuration, no excited triplet energy transfer occurs as long as intermediate excitation medium 18a is not exposed to excitation light. Moreover, exposure to excitation light is accomplished with intermediate excitation medium 18a and first molecule 28a sufficiently close to one another or in other words with first molecule 28a placed at a distance at which it can be excited by energy for bonding transferred from intermediate excitation medium 18a.

As a result, in this sample configuration not only can excited triplet energy be transferred effectively, but the positioning accuracy and resolution of polymer pattern 32 on substrate 24 can be controlled in single-molecule units based on the intermediate excitation medium.

Next, in this embodiment probe 25 is moved to another position above substrate 24, or in other words scanned, and the aforementioned methods are repeated to form a specific polymer pattern on substrate 24.

Next, polymer pattern 32 is left alone of substrate 24 by methods similar to those used in the first embodiment. Polymer pattern 32, which was formed in response to exposure to excitation light, can then be confirmed by the AFM function of molecular bonding device 100.

As is clear from the explanation above, effects similar to those of the first embodiment can be anticipated with this embodiment. That is, as in the first embodiment, resolution in single-molecule units can be reproducibly obtained by keeping the positioning accuracy of the support with respect to the substrate at 1 nm or less.

Consequently, with this embodiment molecular wiring comprising molecular wires with a width of 1 molecule for example can be prepared by scanning probe 25 on substrate 24. When making molecular wiring, it is effective in some cases to select the combination of intermediate excitation medium 18a and monomer 26 such that one excitation of the intermediate excitation medium produces a cascade in which the molecules are polymerized one after another with each other on the substrate.

Moreover, with this embodiment intermediate excitation medium 18a, which is softer than the probe 23, is fixed on the tip of the probe 25. Deterioration of the probe 23 due to direct contact of the probe 23 itself with the substrate 24 is thus prevented.

### (Third Embodiment)

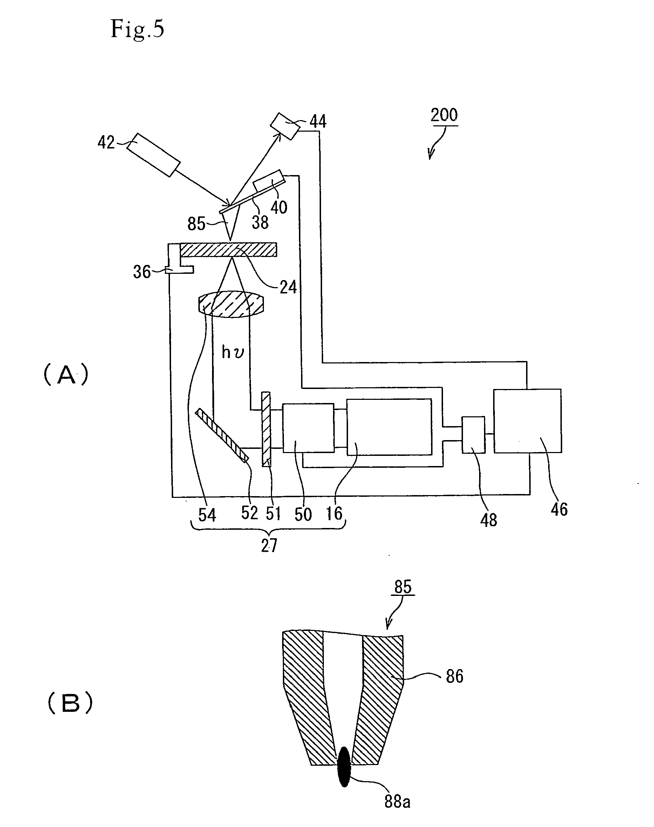

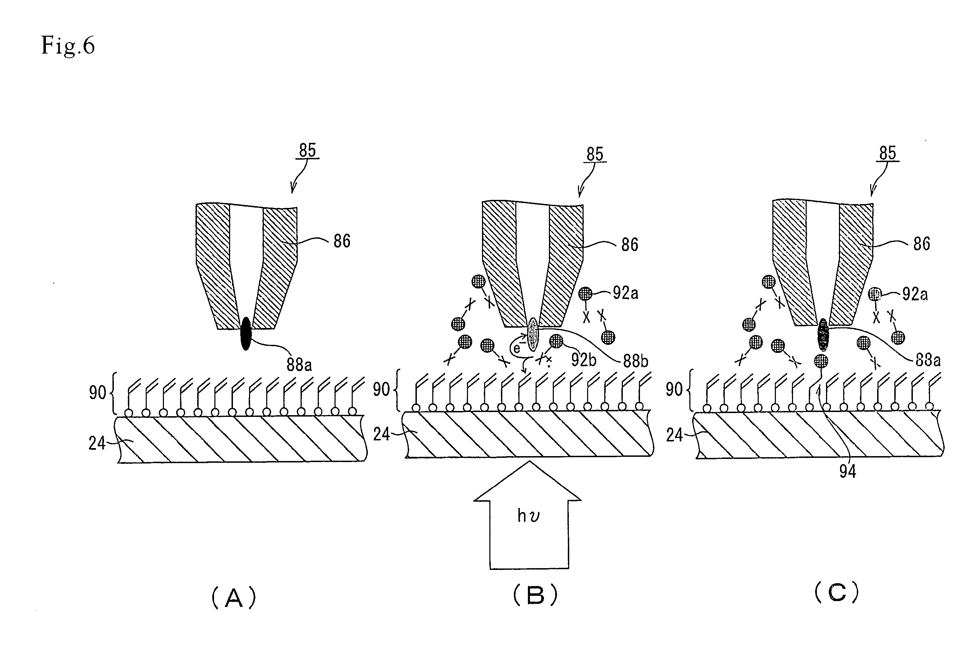

The third embodiment of the present invention will be explained with reference to Figures 5 and 6. This embodiment differs from the second embodiment mainly in that the probe is provided with a photocatalyst as the intermediate excitation medium, and that molecules are arranged in specific positions using radical reactions caused by photoexcited energy transfer.

As shown in Figure 5(A), apart from the configuration of probe 85 molecular bonding device 200 of this embodiment is similar in configuration to molecular bonding device 100 which was explained in the second embodiment, so a detailed explanation thereof will be omitted.

Probe 85 of molecular bonding device 200 of this embodiment will be explained in detail below.

As shown in Figure 5(B), probe 85 is provided with support 86, which forms the body of the probe, and intermediate excitation medium 88a, which is fixed on support 86.

Support 86 of this embodiment is a glass nanopipette probe with a bore of 8 nm. This probe is obtained for example by drawing a glass capillary tube with an outer diameter of 1 mm with a pipette puller (Sutter P2000).

In this embodiment, a titanium dioxide (TiO₂, also called "titania" below) particle about 10 nm in size which is a photocatalyst (also called a photoactive catalyst) is used as intermediate excitation medium 88a. Intermediate excitation medium 88a is not limited thereby, however, and any that functions as a photocatalyst can be selected at will. A photosensitized molecule can also be used instead of a photocatalyst as intermediate excitation medium 88a.

Titania particle 88a, which is the intermediate excitation medium, is then fixed to support 86 by the following procedures.

First, a 0.1 wt% aqueous dispersion of titania particles is prepared. One end of the aforementioned nanopipette 86 is dipped in this aqueous dispersion, and the aqueous dispersion is sucked through the other end by a vacuum pump. In this way, probe (sometimes called photoexcited molecule transfer probe) 85 is obtained having only one of the titania particles fixed to the tip of nanopipette probe 86 by physical adsorption. Probe 85 of this sample configuration has one particle of titania particles 88a as the intermediate excitation medium fixed to the tip of support 86, which is the probe body, but multiple particles can also be fixed to support 86. Moreover, the method of fixing intermediate excitation medium 88a to support 86 is not limited to the above, and any desirable method can be used.

Next, a molecular bonding method using this molecular bonding device 200 will be explained with reference to Figures 6(A), (B) and (C).

This embodiment uses a photosensitization reaction from intermediate excitation molecule 88a fixed on support 86. Specifically, the photosensitization reaction is explained taking as an example a bonding reaction caused by electron transfer (sometimes called photoexcited electron transfer) between the excited intermediate excitation medium and the first molecule described below. For details regarding photoexcited electron transfer, which is a kind of photocatalytic reaction using a photocatalyst, see "Solar light induced carbon-carbon bond formation via TiO₂ photocatalysis," Laura Cermenati, Christoph Richter and Angelo Albini, *Chem. Commun.,* 805-806 (1998).

First, the silane coupling agent 3-acryloxypropyltrimethoxysilane (Shinetsu Chemical Industries, Shinetsu Silicone) 90 shown by Formula (23) below is fixed on the substrate 24, which is the fixing member (also called the support member).

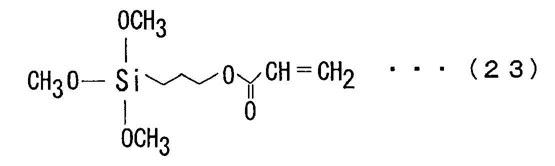

Specifically, first an aqueous acetic acid solution (concentration 0.05 wt% to 0.1 wt%) was agitated as 3-acryloxypropyltrimethoxysilane was dripped in slowly to a concentration of 0.2 wt%. After completion of dripping, this was agitated for 60 minutes and filtered with a filter cartridge with a pore size of 0.45 µm.

The resulting filtrate can be applied to substrate 24 by dip coating and dried for 5 minutes at 110°C to fix the 3-acryloxypropyltrimethoxysilane on substrate 24. The 3-acryloxypropyltrimethoxysilane 90 becomes second molecule 90, which has a bonding residue and is the bonding target of first molecule 92a, which has a bonding residue which is excited by photoexcited electron transfer. First molecule 92a is sometimes called the molecule to be fixed because it is fixed to substrate 24 by the subsequent bonding reaction. Second molecule 90 is sometimes called the fixed molecule because it is already fixed to substrate 24.

Next, substrate 24 with second molecule 90 is set in a scanner (see Figure 5(A), and second molecule 90 on substrate 24 is arranged facing titania particle 88a of probe 85 at a specific distance (see Figure 6(A)). At this stage when no external energy is being supplied to titania particle 88a which is the intermediate excitation medium, no photoexcited electron transfer occurs.

Next, a suitable amount of the 4-methoxybenzyltrimethylsilane shown by Formula (24) below as the first molecule having radical-generating groups is supplied between titania particle 88a and substrate 24. A solution of 0.2 g of 4-methoxybenzyltrimethylsilane dissolved in 40 ml acetonitrile (CH₃CN) for example is supplied here.

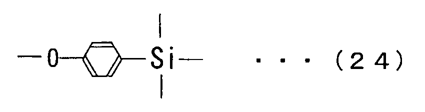

Next, titania particle 88a is supplied with (exposed to) external energy in the form of excitation light from second mercury xenon lamp 16 in a method similar to that used in the second embodiment. Exposure here is to pulse light or in other words to intermittent light at an intensity of 2 mW/cm² from mercury xenon lamp 16 which has passed through a band-pass filter 51 with a transmissible wavelength range of 365 nm and a half band width of 50 nm. The light intensity may be any intensity at which one intermediate excitation medium 18a is exposed to and excited by at least one photon, and can be set at will by selecting the configuration and materials of the device and the like.

When exposed to external energy, titanium particle 88a fixed on support 86 is excited and becomes titania 88b in an excited state (also called an active state).

As a result, photoexcited electron transfer occurs between titania particle 88b and first molecule 92a, which is in the vicinity of titania particle 88b (electron donation from first molecule 92a to titania particle 88b in an excited state is explained here, but in some cases electrons may be donated in the opposite direction from excited titania particle 88b to first molecule 92a). That is, photoexcited electron transfer occurs between titania particle 88b and first molecule 92a, which is within the range of possible electron transfer from titania particle 88b. Due to this electron transfer, first molecule 92a is oxidized, becoming radical ion 92b in an excited state (see Figure 6(B)). One radical is produced each time titania particle 88a is excited.

As a result, first molecule 92b, which is now a radical ion, is bonded by a radical reaction to a specific bonding target, second molecule 90, which is in the vicinity of radical ion 92b, producing combination 94 (see Figure 6(C)). Because this combination 94 is a molecular structure having a framework which functions as first molecule 92a, first molecule 92a can be effectively fixed in a specific position on substrate 24 by this bonding. In this sample configuration, one molecule of first molecule 92a can be fixed in a specific position each time titania particle 88a is excited.

Next, by moving probe 25 to another position on the upper surface of substrate 24 and repeating the methods described above as in the second embodiment, single molecules of first molecule can be successively positioned or in other words fixed on substrate 24. A variety of functional molecules can be used as the first molecule to be fixed here according to the objective and design.

Next, methods similar to those used in the second embodiment can be used to leave combination 94 alone on substrate 24. In this way, combination 94, which was formed in response to exposure to excitation light, can be recognized by the AFM function of molecular bonding device 200.

As is clear from the above explanation, in this embodiment molecules to be fixed can be arranged in specific positions using electron transfer generated when an intermediate excitation medium fixed on a support is excited.

As a result, in this embodiment one molecule of the molecule to be fixed can be fixed with great accuracy in a specific position based on the physical action generated by the intermediate excitation medium when an intermediate excitation medium with a stable excitation state is excited once. That is, in this sample configuration molecules can be positioned with a resolution of a single molecule.

Consequently, optoelectronic elements and other molecular devices can be prepared for example using a functional molecule as the first molecule by arranging such functional molecules in desired positions on a substrate.

When radical ion 92b is generated by oxidation caused by intermediate excitation medium 88a using a semiconductor as in this embodiment, an intermediate excitation medium 88a can be used which has a valence band potential of intermediate excitation medium 88b in the excited state which is higher than the oxidation potential of the radical ion generator. Thus, these combinations can be selected as desired according to the objective and design. Moreover, an acceptor which accepts electrons excited in the conduction band by photoexcitation can also be supplied together with the first molecule as necessary when supplying the first molecule. The acceptor here may be any with a reduction potential lower than the conduction band potential of the intermediate excitation medium, and when the intermediate excitation medium is titania, maleic acid can be used for example. Moreover, although in this embodiment the bonding target was the second molecule, the bonding target may also be a substrate or other material other than a molecule. A configuration is also possible in which the molecule which becomes the radical ion is a fixed molecule and the bonding target is the molecule to be fixed.

A photosensitized molecule can be used instead of a semiconductor as intermediate excitation medium 88a. In photoexcited electron transfer using a photosensitized molecule, the reduction potential of the photoexcited molecule in an excited state should be higher than the oxidation potential of the radical generator. Consequently, these combinations can be selected as desired according to the objective and design. For example 1,4-naphthalenedicarbonitrile can be used as the photosensitized molecule and toluene can be arranged as the first molecule. The acceptor in this case can be any with a reduction potential higher than the reduction potential of the ground state of the photosensitized molecule. Details are described in "Radical addition to alkenes via electron transfer photosensitization," M. Fagnoni, M. Mella and A. Albini, J. *Am. Chem.* Soc. 117, 7877 (1995) and "Electron-transfer-photosensitized conjugate alkylation," M. Fagnoni, M. Mella and A. Albini, J. *Org. Chem.* 63, 4026 (1998).

The present invention is not limited only to the combinations of the aforementioned embodiments. Therefore, favorable conditions can be combined at any stage and applied to the present invention.

For example, photoexcited energy transfer was used in the aforementioned first and second embodiments, but a configuration using photoexcited electron transfer would also be acceptable. In the aforementioned third embodiment photoexcited electron transfer was used, but a configuration using photoexcited energy transfer would also be acceptable.

Moreover, in the aforementioned embodiments the intermediate excitation medium was exposed to external energy in the form of light, but any other form such as electrons, ions or the like can be selected according to the objective and design.

In the aforementioned embodiments examples were explained using a sapphire substrate as the fixing member or in other words as the substrate, but a silicon substrate, gold substrate or the like could also be used, and resolution in single-molecule units can also be obtained using these.

### INDUSTRIAL APPLICABILITY

As is clear from the foregoing explanation, in the present invention a first molecule having a bonding residue which is in the vicinity of excited intermediate excitation medium can be bonded selectively to a bonding target to be bonded to the first molecule by exciting an intermediate excitation medium fixed on a support.

As a result, not only is bonding between the first molecule and the bonding target accomplished via the stable excited state of the intermediate excitation medium, but resolution in single-molecule units can be obtained with good control based on the intermediate excitation medium.

Consequently, the molecular bonding device and molecular bonding method of the present invention, which allow arrangement of molecules and bonding between molecules in single-molecule units, are suited to use in the manufacture of semiconductor devices, molecular devices and the like.

## Claims

1. A molecular bonding method wherein external energy is supplied to an intermediate excitation medium fixed on a support to excite said intermediate excitation medium, thereby bonding a first molecule having a bonding residue, which is in the vicinity of said intermediate excitation medium which has been excited, with a bonding target to be bonded to said first molecule.

2. The molecular bonding method according to Claim 1, wherein said bonding is accomplished with either one or both of said first molecule and said bonding target fixed to a fixing member.

3. The molecular bonding method according to Claim 2, wherein said bonding is accomplished with said support positioned accurately enough with respect to said fixing member so as to achieve said bonding.

4. The molecular bonding method according to Claim 3, wherein said bonding is accomplished with said accuracy of 1 nm or less.

5. The molecular bonding method according to any one of Claims 1 through 4, wherein said bonding is accomplished by means of bonding energy which moves from said intermediate excitation medium which has been excited to said first molecule.

6. The molecular bonding method according to Claim 5, wherein movement of bonding energy from said intermediate excitation medium to said first molecule is accomplished by excited triplet energy transfer.

7. The molecular bonding method according to any one of Claims 1 through 4, wherein said bonding is accomplished due to transfer of electrons between said intermediate excitation medium which has been excited and said first molecule.

8. The molecular bonding method according to any one of Claims 1 through 7, wherein said external energy is supplied by supplying light, electrons or ions to said intermediate excitation medium.

9. The molecular bonding method according to Claim 8, wherein, when said intermediate excitation medium is a photosensitized molecule, said external energy is supplied by exposure to said light.

10. The molecular bonding method according to Claim 9, wherein a N-acetyl-4-nitro-1-naphthylamine derivative is used as said photosensitized molecule.

11. The molecular bonding method according to Claim 7, wherein, when said intermediate excitation medium is a photocatalyst, said external energy is supplied by exposure to said light.

12. The molecular bonding method according to Claim 11, wherein titanium dioxide is used as said photocatalyst.

13. The molecular bonding method according to any one of Claims 1 through 12, wherein a second molecule having a bonding residue is used as said bonding target.

14. The molecular bonding method according to any one of Claims 1 through 12, wherein a material other than a molecule is used as said bonding target.

15. A molecular bonding device comprising:
a support;
an intermediate excitation medium fixed on said support; and
an external energy supply which supplies said intermediate excitation medium with external energy to excite said intermediate excitation medium, thereby bonding a first molecule which has a bonding residue and which is in the vicinity of said excited intermediate excitation medium with a bonding target which is to be bonded to said first molecule.

16. The molecular bonding device according to Claim 15, wherein either one or both of said first molecule and said bonding target is fixed to a fixing member.

17. The molecular bonding device according to Claim 16, wherein said support is positioned accurately enough with respect to said fixing member so as to achieve said bonding.

18. The molecular bonding device according to Claim 17, wherein said accuracy is 1 nm or less.

19. The molecular bonding device according to any one of Claims 15 through 18, wherein said intermediate excitation medium which has been excited generates bonding energy which moves from said intermediate excitation medium which has been excited to said first molecule to achieve said bonding.

20. The molecular bonding device according to any one of Claims 15 through 18, wherein said intermediate excitation medium which has been excited accomplishes said bonding by transfer of electrons between said intermediate excitation medium which has been excited and said first molecule.

21. The molecular bonding device according to any one of Claims 15 through 20, wherein said external energy is light, electrons or ions.

22. The molecular bonding device according to Claim 21, wherein when said intermediate excitation medium is a photosensitized molecule, said external energy is said light.

23. The molecular bonding device according to Claim 22, wherein said photosensitized molecule is a N-acetyl-4-nitro-1-naphthylamine derivative.

24. The molecular bonding device according to Claim 21, wherein, when said intermediate excitation medium is a photocatalyst, said external energy is said light.

25. The molecular bonding device according to Claim 24, wherein said photocatalyst is titanium dioxide.

26. The molecular bonding device according to any one of Claims 15 through 25, wherein said bonding target is a second molecule having a bonding residue.

27. The molecular bonding device according to any one of Claims 15 through 25, wherein said bonding target is a material other than a molecule.

28. The molecular bonding device according to any one of Claims 15 through 27, wherein said intermediate excitation medium is fixed to said support by chemical bonds.

29. The molecular bonding device according to any one of Claims 15 through 28, wherein said bonding residue is an aliphatic residue having an unsaturated double bond or unsaturated triple bond.

30. The molecular bonding device according to any one of Claims 15 through 28, wherein said bonding residue is an aromatic residue having an unsaturated double bond or unsaturated triple bond.

31. The molecular bonding device according to Claim 30, wherein, when said aromatic residue having said unsaturated double bond is a cinnamic acid residue, said intermediate excitation medium is N-[3-{3,5-bis{3,5-bis[3,5-bis(4-mercaptobenzylthio)benzylthio]benzylthio}benzyloxy}-propionyl-4-nitro-1-naphthylamine.
